# EUROPEAN PATENT APPLICATION

(11) **EP 4 672 074 A1**
(43) Date of publication of application: **31.12.2025**
(21) Application number: 25176290.2
(22) Date of filing: 14.05.2025
(51) Int. Cl.: G06F 30/15, G06F 30/17, G06F 30/20, G05B 19/418

(54) **SYSTEMS AND METHODS FOR PREDICTIVE ASSEMBLY**

(30) Priority: 26.06.2024 US 202463664340 P; 27.01.2025 US 202519037605
(71) Applicant: The Boeing Company, Arlington, VA 22202 (US)
(72) Inventor: RENNISON, Benjamin, Arlington, 22202 (US)
(74) Representative: Morrall, Jonathan Ian McLachlan

(57) **Abstract**

A system for predictive assembly includes a model generator, a model analyzer, and an assembly planner. The model generator generates a first model of a first component and a second model of a second component before the first component and the second component are coupled together. The model analyzer analyzes the first model and the second model to determine a dimension of a gap between a first mating surface of the first component and a second mating surface of the second component after the first component and the second component are coupled together. The assembly planner recommends an action based on a comparison of the gap to a gap threshold.

## Description

### PRIORITY

This application claims priority from U.S. Ser. No. 63/664,340 filed on June 26, 2024, the entire contents of which are incorporated herein by reference.

### FIELD

The present disclosure relates generally to predictive assembly and, more particularly, to systems and methods for predictive assembly based on predicted gaps between mating surfaces.

### BACKGROUND

Various surfaces are mated when components are coupled together during manufacture of an object. In some cases, after being coupled together, one or more gaps are present between the mated surfaces. However, certain manufacturing requirements may not allow for gaps greater than a certain threshold or for gaps to be filled. As such, gaps over the threshold may require disassembly and remanufacturing of one or both of the components. While techniques exist for predicting gaps between mated surfaces, conventional predictive assembly methods may be unable to adequately predict the dimensions of the gaps when one or more of the components has a geometry during measurement that is different than its geometry after being coupled to another component. Accordingly, those skilled in the art continue with research and development efforts in the field of predictive assembly.

### SUMMARY

Disclosed are examples of a system for predictive assembly, a method for predictive assembly and a computer program product for predictive assembly. The following is a non-exhaustive list of examples, which may or may not be claimed, of the subject matter according to the present disclosure.

In an example, the disclosed system includes a model generator, a model analyzer, and an assembly planner. The model generator generates a first model of a first component and a second model of a second component before the first component and the second component are coupled together. The model analyzer analyzes the first model and the second model to determine a dimension of a gap between a first mating surface of the first component and a second mating surface of the second component after the first component and the second component are coupled together. The assembly planner recommends an action based on a comparison of the gap to a gap threshold.

In an example, the disclosed method includes steps of: (1) generating a first model of a first component and generating a second model of a second component before the first component and the second component are coupled together; (2) filtering out a deformation of at least one of the first component and the second component before the first component and the second component are coupled together; and (3) determining a dimension of a gap between a first mating surface of the first component and a second mating surface of the second component after the first component and the second component are coupled together; and (4) recommending an action based on the dimension of the gap.

In another example, the disclosed method includes steps of: (1) generating a first model of a first component and a second model of a second component before the first component and the second component are coupled together; (2) analyzing the first model and the second model to determine a dimension of a gap between a first mating surface of the first component and a second mating surface of the second component after the first component and the second component are coupled together; and (3) recommending an action based on a comparison of the gap to a gap threshold.

In an example, the disclosed computer program product includes computer-readable medium which may be non-transitory, including program code that, when executed by one or more processors, causes the one or more processors to perform operations comprising: (1) generating a first model of a first component from first data before the first component is coupled to a second component; (2) generating a second model of a second component from second data before the second component is coupled to the first component; (3) determining a first overall deviation in a normal direction between the first model and a first nominal model of the first component; (4) determining a second overall deviation in the normal direction between the second model and a second nominal model of the second component; (5) performing a best fit alignment between the first model and the first nominal model of the first component to determine the first overall deviation; (6) performing the best fit alignment between the second model and the second nominal model of the second component to determine the second overall deviation; (7) determining a first overall dimension of the first overall deviation in the normal direction; (8) determining a second overall dimension of the second overall deviation in the normal direction; (9) mapping the first overall deviation from an XYZ-coordinate system to a UVW-coordinate system such that first values for the first dimensions of the first overall deviation are represented along a W-axis; (10) mapping the second overall deviation from the XYZ-coordinate system to the UVW-coordinate system such that second values for the second dimensions of the second overall deviation are represented along the W-axis; (11) filtering the first values for the first dimensions of the first overall deviation into a first form deviation and a first waviness deviation; (12) filtering the second values for the second dimensions of the second overall deviation into a second form deviation and a second waviness deviation; (13) mapping the first waviness deviation from the UVW-coordinate system to the XYZ-coordinate system such that first values for first waviness dimensions of the first waviness deviation are represented as first distances relative to the first nominal model; (14) mapping the second waviness deviation from the UVW-coordinate system to the XYZ-coordinate system 126 such that second values for second waviness dimensions of the second waviness deviation are represented as second distances relative to the second nominal model; (15) modifying the first nominal model of the first component by the first waviness deviation such that a first modified nominal model represents the first mating surface of the first component after the first component and the second component are coupled together; (16) modifying the second nominal model of the second component by the second waviness deviation such that a second modified nominal model represents the second mating surface of the second component after the first component and the second component are coupled together; (17) analyzing the first modified nominal model and the second modified nominal model to determine dimensions of a gap between a first mating surface of the first component and a second mating surface of the second component after the first component and the second component are coupled together; and recommending an action based on a comparison of the gap to a gap threshold, wherein the action includes one of: coupling the first component and the second component together when the dimension of the gap is less than or equal to the gap threshold; reprocessing at least one of the first component and the second component when the dimension of the gap is greater than the gap threshold; redesigning at least one of the first component and the second component when the dimension of the gap is greater than the gap threshold; and repairing at least one of the first component and the second component when the dimension of the gap is greater than the gap threshold.

In an example, the disclosed system implements the disclosed method.

In an example, the disclosed computer program product implements the disclosed method.

In an example, the disclosed method is performed using an example of the disclosed system or the disclosed computer program product.

In an example, a portion of an aircraft is manufactured and assembled using the disclosed system or the disclosed computer program product or according to the disclosed method.

Other examples of the fitting, the connection assembly, and the method will become apparent from the following detailed description, the accompanying drawings, and the appended claims.

### BRIEF DESCRIPTION OF THE DRAWINGS

Fig. 1 is a schematic block diagram of an example of a manufacturing environment;
Figs. 2A and 2B are a schematic block diagram of an example of an analysis environment;
Fig. 3 is a schematic illustration of an example of an aircraft;
Fig. 4 is a schematic illustration of an example of a portion of an object manufactured by joining components;
Fig. 5 is a graphical illustration of an example of a portion of a first nominal model representing a first component and a second nominal model representing a second component;
Fig. 6 is a graphical illustration of an example of a portion of a first model representing the first component and the second model representing a second component;
Fig. 7 is a graphical illustration of an example of a portion of the first model representing the first component and the second model representing the second component;
Fig. 8 is a graphical illustration of an example of a portion of a first modified nominal model representing the first component and a second modified nominal model representing the second component;
Fig. 9 is a graphical illustration of an example of an overall deviation between a first model and a nominal model in an XYZ-coordinate system;
Fig. 10 is a graphical illustration of an example of the overall deviation between the first model and the nominal model in an UVW-coordinate system;
Fig. 11 is a graphical illustration of an example of a form deviation between the first model and the nominal model in the UVW-coordinate system;
Fig. 12 is a graphical illustration of an example of a waviness deviation between the first model and the nominal model in the UVW-coordinate system;
Fig. 13 is a graphical illustration of an example of the waviness deviation between the first model and the nominal model in the XYZ-coordinate system;
Fig. 14 is a flow diagram of an example of a method for predictive assembly;
Fig. 15 is a flow diagram of an example of the method for predictive assembly;
Fig. 16 is a block diagram of an example of a data processing system;
Fig. 17 is a flow diagram of an example of an aircraft manufacturing method; and
Fig. 18 is a schematic block diagram of an example of an aircraft.

### DETAILED DESCRIPTION

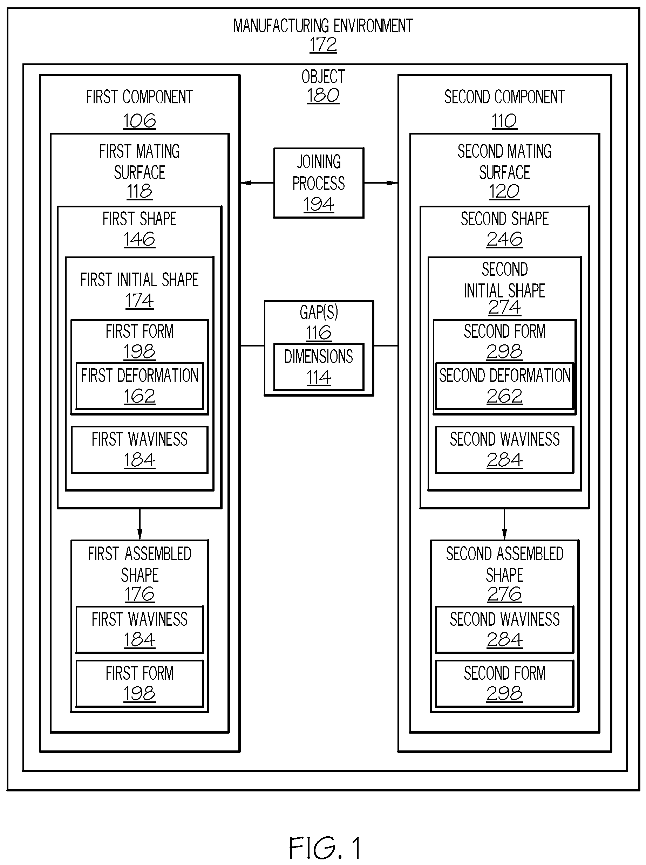

Referring generally to Figs. 1-15, by way of examples, the present disclosure is directed to a system 100 and methods 1000, 2000 for predictive assembly. More particularly, the systems and methods are directed to proactive predictive assembly, which, for the purpose of the present disclosure, refer to improvements in predictive assembly methodologies by which pre-assembly deformation of a component is removed and geometry (e.g., dimensions, shape, size, etc.) of a gap between post-assembly mating surfaces can be predicted and preemptive action can be taken. As examples, pre-assembly deformation of a component is "filtered out" of three-dimensional (3D) measurement data of the component, thereby enabling the 3D measurement data to be used to proactively predict the dimensions of gaps between mating surfaces of joined components.

The present disclosure recognizes that traditional assembly methods may not be capable of accurately capturing variations in the surfaces of components being joined. The present disclosure also recognizes that traditional predictive assembly may not be capable of sufficiently accounting for deformation of a component when it is measured, thereby resulting in excessively large gaps after assembly Thus, it is only after assembly and measurement of gaps that a determination can be made if manufacturing tolerances have been met. Accordingly, it is desirable to have systems and methods for predicting gaps between surfaces that accounts for deformation and recommending actions based on the predicted gaps.

The disclosed systems and methods utilize data filtering, such as a robust Gaussian areal regression filter, on 3D measurement data representing the component to robustly filter out the deformation of the component, while preserving waviness (e.g., peaks and valleys) of a mating surface relevant to a gap between surfaces. The shape (e.g., direction and magnitude of the dimension) representing the waviness is offset to accurately predict any gaps prior to component assembly.

Fig. 1 illustrates an example of a manufacturing environment 172. The manufacturing environment 172 is an example of a manufacturing environment in which an object 180 is manufactured.

In one or more examples, the object 180 includes, or is manufactured using, a plurality of components, such as at least a first component 106 and a second component 110. In various other examples, any number of other components may also be used to form or manufacture the object 180. The first component 106 includes a first mating surface 118 and the second component 110 includes a second mating surface 120. As used herein, a "surface" refers to a continuous surface or a discontinuous surface formed of multiple surfaces.

In one or more examples, the first component 106 and the second component 110 are joined, attached, or otherwise coupled together such that the first mating surface 118 and the second mating surface 120 are mated together. For example, the first component 106 and the second component 110 are joined and, thus, the first mating surface 118 and the second mating surface 120 are mated using any suitable joining process 194.

In one or more examples, the joining process 194 includes any number of operations configured to physically attach the first component 106 and the second component 110 such that first mating surface 118 and the second mating surface 120 are mated together. For example, without limitation, the joining process 194 may include at least one of securing, bonding, mounting, welding, fastening, pinning, stitching, stapling, tying, gluing, or otherwise coupling the first component 106 and the second component 110 together.

In one or more examples, the first component 106 and the second component 110 are made from any suitable material or combination of materials. In one or more examples, the first component 106 and the second component 110 are made from the same material. In one or more examples, the first component 106 and the second component 110 are made from different materials. For example, without limitation, the first component 106 and the second component 110 may be made from metallic materials, composite materials, polymeric materials, combinations thereof, and the like.

In one or more examples, the first component 106 and, thus, each one of the first mating surface 118 has a first shape 146. In one or more examples, the second component 110 and, thus, the second mating surface 120 has a second shape 246.

For the purpose of the present disclosure and as used herein, the "shape" of a component or a surface refers to the geometry of the component or the surface, the dimensions of the component or the surface, and the morphology of the component or the surface. As an example, the shape of a component or a surface is the three-dimensional shape of the component or the surface.

In one or more examples, the first shape 146 includes a first form 198 and a first waviness 184.In one or more examples, the second shape 246 includes a second form 298 and a second waviness 284.

For the purpose of the present disclosure and as used herein, "form" refers to the gross or global shape of a component or surface. For the purpose of the present disclosure and as used herein, "waviness" refers to local variations or undulations in the shape of a component or surface.

In one or more examples, the first shape 146 of the first component 106 and, thus, the first mating surface 118 may change throughout the assembly process of the object 180, for example, from manufacture to assembly. In one or more examples, the second component 110 and, thus, the second mating surface 120 may change throughout the assembly process of the object 180, for example, from manufacture to assembly.

In one or more examples, the first component 106 and, thus, the first mating surface 118 has a first initial shape 174 (e.g., the first shape 146 before the joining process 194) and a first assembled shape 176 (e.g., the first shape 146 after the joining process 194). In one or more examples, the second component 110 and, thus, the second mating surface 120 may have a second initial shape 274 (e.g., the second shape 246 before the joining process 194) and a second assembled shape 276 (e.g., the second shape 246 after the joining process 194).

In one or more examples, at least one of the first component 106 and the second component 110 and, thus, at least one of the first mating surface 118 and the second mating surface 120 may experience or exhibit some degree of deformation in the shape at some point between manufacture and assembly (e.g., joining) of the object 180. As an example, the first component 106 and, thus, the first mating surface 118 can experience or exhibit some degree of first deformation 162 in the first shape 146. As an example, the second component 110 and, thus, the second mating surface 120 can experience or exhibit some degree of second deformation 262 in the second shape 246.

For the purpose of the present disclosure and as used herein, "deformation" refers to a temporary variation in the form of the shape. In the examples disclosed herein, the deformation is substantially removed from the shape of a component after or as a result of assembly of the object 180 (e.g., after the joining process 194). As an example, the first deformation 162 is represented in the first initial shape 174 and is not represented in the first assembled shape 176. As an example, the second deformation 262 is represented in the second initial shape 274 and is not represented in the second assembled shape 276.

In one or more examples, the first component 106 is susceptible to experiencing or exhibiting some degree of first deformation 162 (e.g., global deformation) after manufacturing such that the first mating surface 118 also exhibits some degree of first deformation 162. As an example, the first component 106 may be flexible such that the first mating surface 118 is also flexible. As an example, the first component 106 may temporarily bend, deform, flex, sag, or otherwise change shape without causing any undesired permanent effects to the first component 106 or the first mating surface 118.

In one or more examples, the second component 110 is susceptible to experiencing or exhibiting some degree of second deformation 262 (e.g., global deformation) after manufacturing such that the second mating surface 120 also exhibits some degree of second deformation 262. As an example, the second component 110 may be flexible such that the second mating surface 120 is also flexible. As an example, the second component 110 may temporarily bend, deform, flex, sag, or otherwise change shape without causing any undesired permanent effects to the second component 110 or the second mating surface 120.

This non-permanent change in shape (e.g., deformation) can be due to a number of factors, such as the size, geometry, weight, etc. of the component after it is manufactured, boundary conditions, gravity, and the like. Consequently, in these examples, the shape of the component and, thus, the mating surface may change throughout the manufacturing process of the object 180.

As an example, the first component 106 and, thus, the first mating surface 118 can have the first initial shape 174 before assembly of the object 180 and the first assembled shape 176 after assembly of the object 180. In these examples, the first initial shape 174 and the first assembled shape 176 are different and are a result of the first deformation 162.

As an example, the second component 110 and, thus, the second mating surface 120 can have the second initial shape 274 before assembly of the object 180 and the second assembled shape 276 after assembly of the object 180. In these examples, the second initial shape 274 and the second assembled shape 276 are different and are a result of the second deformation 262.

In other examples, the second component 110 is not susceptible to experiencing or exhibiting the second deformation 262 after manufacturing such that the second mating surface 120 also does not exhibit the second deformation 262. As an example, the second component 110 may be rigid such that the second mating surface 120 is also rigid. As an example, the second component 110 may be unable to bend, deform, flex, sag, or otherwise change shape without causing any undesired permanent effects to the second component 110 or the second mating surface 120. Consequently, in these examples, the second shape 246 of the second component 110 and, thus, the second mating surface 120 may not change throughout the manufacturing process of the object 180. As an example, the second component 110 and, thus, the second mating surface 120 can have the second initial shape 274 before assembly of the object 180 and the second assembled shape 276 after assembly of the object 180. In these examples, the second initial shape 274 and the second assembled shape 276 are substantially the same.

In one or more examples, the second component 110 provides or serves as a supporting structure for the object 180 to which the first component 106 is coupled. Accordingly, the first component 106 and, thus, the first mating surface 118 have the first assembled shape 176 after coupling the first component 106 and the second component 110 together. As an example, fit-up forces may pull the first deformation 162 out of the first component 106 during assembly of the object 180. In these examples, the magnitude of the difference between the first initial shape 174 and the first assembled shape 176 may be due to a number of factors, such as the loads and/or forces applied to the first component 106 during the joining process 194, a number of attachment points between the first component 106 and the second component 110, the orientation of the first component 106 and/or the second component 110, and other factors that may affect the first shape 146 of the first component 106 before, during, and/or after the joining process 194.

In one or more examples, a number of gaps 116 may be present between the first mating surface 118 and the second mating surface 120. As used herein, a "number of' refers to one or more. In this manner, a number of gaps 116 includes one gap 116 or a plurality of gaps 116. For the purposes of the present disclosure, a "gap" refers to an open space between the mating surfaces of the components forming the object 180. Accordingly, the gap 116 may also be referred to as a space.

In one or more examples, the gap 116 (e.g., each one of the number of gaps 116) has dimensions 114. Generally, the dimensions 114 of the gap 116 refer to a measurable parameter or shape of the gap 116, such its thickness, length, width, etc. More particularly, the dimensions 114 of the gap 116 refer to the thickness of the gap 116 or the linear distances between the first mating surface 118 and the second mating surface 120.

In some cases, it is desirable to predict the dimensions 114 of the gaps 116 and to proactively modify the assembly operation, the joining process, the design of the components, and the like, as needed, before manufacturing and/or shipping the components, before the joining process 194, and/or before assembly of the object 180. Therefore, it is desirable to predict the dimensions 114 (e.g., 3D shape information) for the gaps 116 that would be formed between the first mating surface 118 and the second mating surface 120. In other words, the gaps 116 would be formed after the first component 106 and the second component 110 are coupled together. The gaps 116 are predicted before the first component 106 and the second component 110 are coupled together.

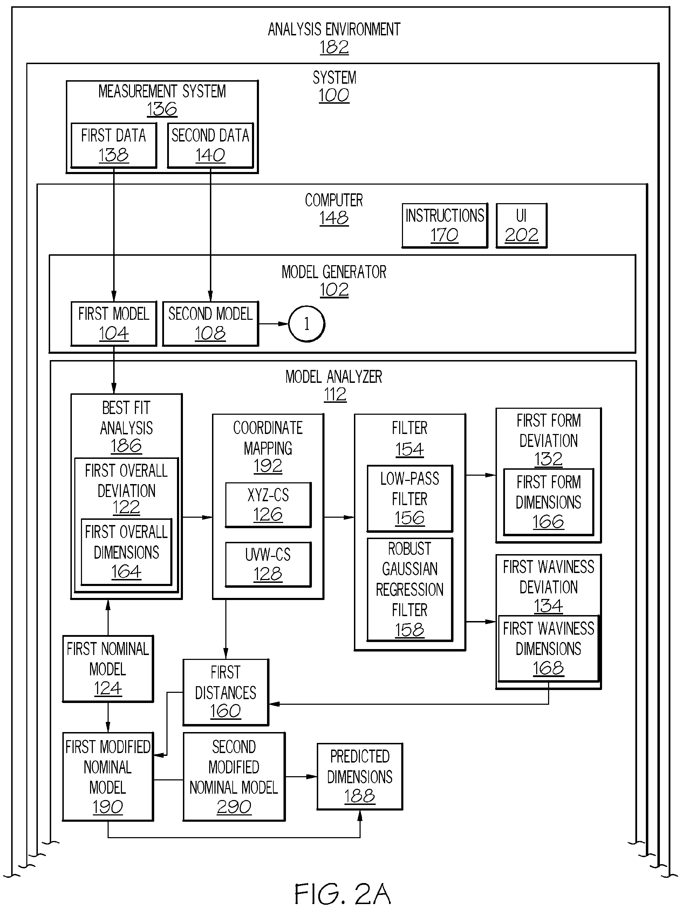

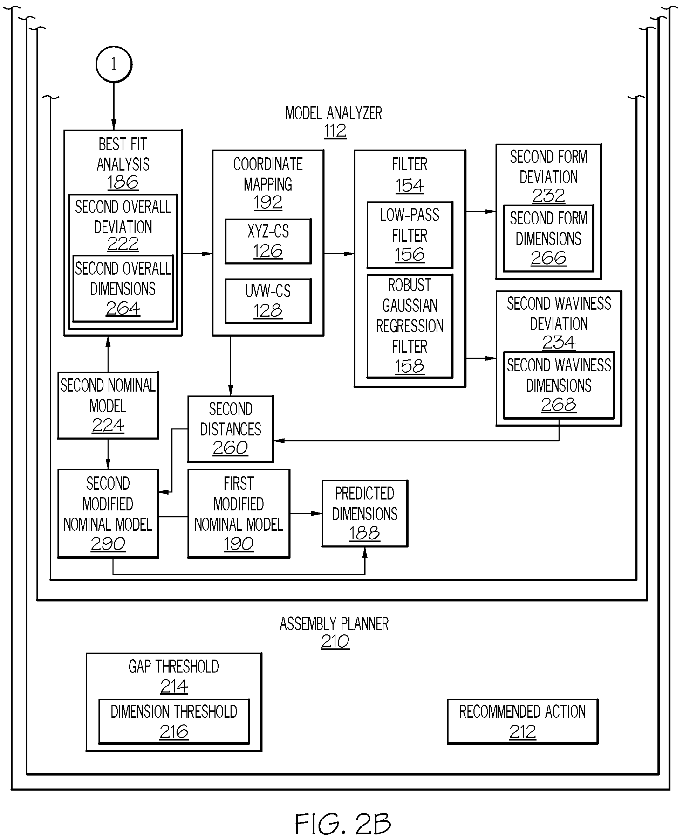

Accordingly, as disclosed herein, the system 100 (Fig. 2) for predictive assembly is used to predict the dimensions 114 of the gaps 116, the number of the gaps 116, and other information related to the gaps 116 and to determine a recommended (e.g., preemptive or corrective) manufacturing action based on the gap predictions before the components are manufactured and/or before the components are assembled to form the object.

Figs. 2A and 2B, collectively referred to herein as Fig. 2, illustrate an example of an analysis environment 182. The analysis environment 182 is an example of an analysis environment in which the system 100 is implemented to proactively predict the dimensions 114 (e.g., 3D shape information) of the gaps 116 (Fig. 1). In one or more examples, the analysis environment 182 is remote from or is at a separate location with respect to the manufacturing environment 172. However, in other examples, at least a portion of the system 100 is located or implemented in the manufacturing environment 172, which at least another portion of the system 100 is located or implemented in the analysis environment 182. In yet other examples, an entirety of the system 100 is implemented in the manufacturing environment 172.

In one or more examples, the system 100 includes or is implemented using a computer 148. For example, the system 100 is a computer-implemented system. In one or more examples, the computer 148 executes instructions 170 to perform the operations performed by the system 100. In these examples, the computer 148 may include one or more computers, computing devices, or computing systems. When the computer 148 includes more than one computer, the computers may be in communication with each other using any number of wired, wireless, optical, or other types of communications links.

In one or more examples, the system 100 includes a model generator 102. The model generator 102 generates (e.g., is configured or adapted to generate) a first model 104 of the first component 106 (Fig. 1). The model generator 102 also generates (e.g., is configured or adapted to generate) a second model 108 of the second component 110 (Fig. 1).

In one or more examples, the first model 104 is generated before the first component 106 and the second component 110 are coupled together. In one or more examples, the first model 104 represents the first component 106 and, thus, the first mating surface 118 having the first initial shape 174.

In one or more examples, the first initial shape 174 of the first component 106 is different than the first assembled shape 176 (e.g., final shape after the joining process 194). In one or more examples, the first initial shape 174 includes the first deformation 162 in the first shape 146 of the first component 106 (e.g., the first component 106 is flexible).

In one or more examples, the second model 108 is generated before the first component 106 and the second component 110 are coupled together. In one or more examples, the second model 108 represents the second component 110 and, thus, the second mating surface 120 having the second initial shape 274.

In one or more examples, the second initial shape 274 of the second component 110 is different than the second assembled shape 276 (e.g., final shape after the joining process 194). In one or more examples, the second initial shape 274 includes the second deformation 262 in the second shape 246 of the second component 110 (e.g., the second component 110 is flexible).

In one or more examples, the second initial shape 274 of the second component 110 is the same as the second assembled shape 276 (e.g., final shape after the joining process 194). In one or more examples, the second initial shape 274 does not include the second deformation 262 in the second shape 246 of the second component 110 (e.g., the second component 110 is rigid).

In one or more examples, the system 100 includes a model analyzer 112. The model analyzer 112 analyzes (e.g., is configured or adapted to analyze) the first model 104 and the second model 108 to determine (e.g., predict) a dimension 114 of a gap 116 that will be formed between the first mating surface 118 of the first component 106 and the second mating surface 120 of the second component 110 after the first component 106 and the second component 110 are coupled together (e.g., following the joining process 194).

As used herein, singular use of the term "dimension" can refer to a single dimension (e.g., dimension 114) or to one or more of a plurality of dimensions (e.g., dimensions 114) of one or more gaps 116. Also, as used herein, singular use of the term "gap" can refer to a single gap (e.g., gap 116) or to one or more of a plurality of gaps (e.g., gaps 116).

In instances where mating surfaces of coupled components can change shape upon assembly, examples of the system 100 account for a post-assembly shape of a component and predict gap geometry based on a manufactured shape of the component. In one or more examples, the system 100 facilitates proactively removing the first deformation 162 from the first shape 146 of the first component 106 during a predictive assembly operation. In one or more examples, the system 100 facilitates proactively removing the second deformation 262 from the second shape 246 of the second component 110 during the predictive assembly operation.

Examples of the system 100 and methods 1000, 2000 disclosed herein enable prediction of the dimensions 114 of the gaps 116 that will be formed between the first mating surface 118 and the second mating surface 120. The predictions of the dimensions 114 of the gaps 116 is performed using an approximation of the first assembled shape 176 of the first component 106 and/or the second assembled shape 276 of the second component 110 (e.g., the final shape after the joining process 194). Such predictions of the dimensions 114 of the gaps 116 enable proactive and/or preemptive modifications to the manufacturing process if needed when predictions of the dimensions 114 of the gaps 116 are greater than the dimensions allowable based on manufacturing specifications or tolerances. Thus, examples of the system 100 and methods 1000, 2000 disclosed herein improve the speed, cost, and efficiency of manufacturing and reduce the amount of waste associated with nonconforming components.

In one or more examples, the system 100 includes an assembly planner 210. The assembly planner 210 compares (e.g., is configured or adapted to compare) the predictions of the dimension 114 of the gap 116 to a gap threshold 214. The assembly planner 210 also recommends (e.g., is configured or adapted to recommend) an action 212 based on the comparison of the gap 116 (e.g., dimension 114) to the gap threshold 214.

For the purpose of the present disclosure and as used herein, the gap threshold 214 refers to a specific limit or point that must be met before a determination is made or an action is taken. The gap threshold 214 can refer to any measurable parameter or characteristic of the gap or space between mating surfaces of components and can be based on manufacturing design, specifications, and/or tolerances. As an example, the gap threshold 214 is a dimensional threshold (e.g., dimension threshold 216) representing the maximum allowable distance (e.g., gap size) between mating surfaces of components after being joined.

In instances where the predicted dimension 114 of the gap 116 is equal to or less than the dimension threshold 216 of the gap threshold 214, the action 212 (e.g., recommended by the assembly planner 210) can be to proceed with joining the components and assembly of the object 180 (Fig. 1). However, in instances where the predicted dimension 114 of the gap 116 is equal to or greater than the dimension threshold 216 of the gap threshold 214, the action 212 (e.g., recommended by the assembly planner 210) can be a rework process before manufacturing the components or before joining the components and assembly of the object 180.

In one or more examples, the action 212 recommended by the assembly planner 210 includes coupling the first component 106 and the second component 110 together when the dimension 114 of the gap 116 is less than or equal to the gap threshold 214.

In one or more examples, the action 212 recommended by the assembly planner 210 includes reprocessing at least one of the first component 106 and the second component 110 when the dimension 114 of the gap 116 is greater than the gap threshold 214. In these examples, reprocessing includes refabricating or manufacturing a new instance of the first component 106 and/or the second component 110.

In one or more examples, the action 212 recommended by the assembly planner 210 includes redesigning at least one of the first component 106 and the second component 110 when the dimension 114 of the gap 116 is greater than the gap threshold 214. In these examples, redesigning includes making a change to the design, specification, and/or tolerances of the first component 106, the second component 110, and/or the structural assembly (e.g., object 180) that includes the first component 106 and the second component 110.

In one or more examples, the action 212 recommended by the assembly planner 210 includes repairing at least one of the first component 106 and the second component 110 when the dimension 114 of the gap 116 is greater than the gap threshold 214. In these examples, repairing includes modifying at least one of the first mating surface 118 of the first component 106 and/or the second mating surface 120 of the second component 110, such as by sanding or other surface finishing, to reduce or eliminate the gap 116.

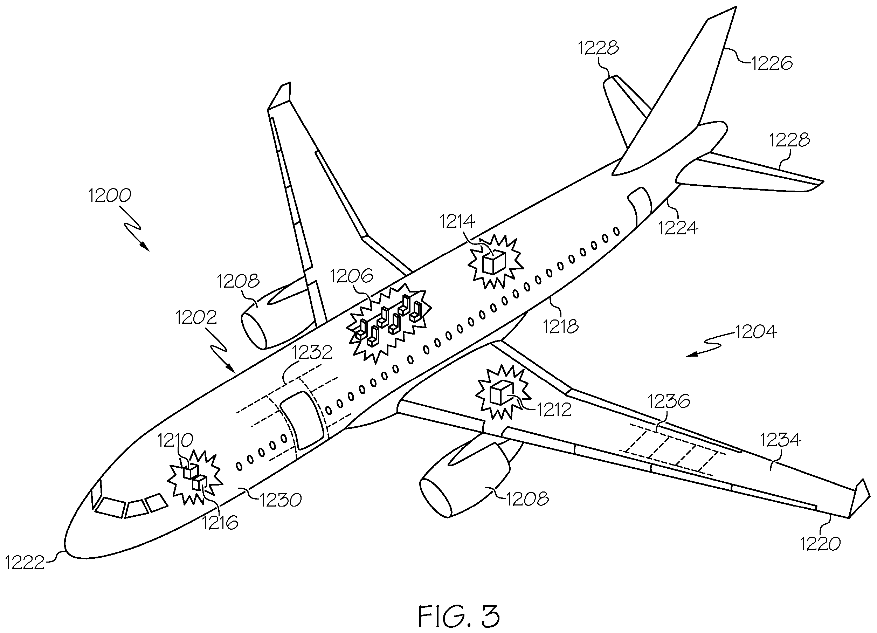

Fig. 3 illustrates an example of an aircraft 1200. In one or more examples, the aircraft 1200 includes a fuselage 1218 (e.g., a body) and wings 1220 attached to the fuselage 1218. The aircraft 1200 includes a propulsion system 1208 (e.g., engines), for example, attached to the wings 1220. The fuselage 1218 has a nose section 1222 and a tail section 1224. The aircraft 1200 includes horizontal stabilizers 1228 and a vertical stabilizer 1226 are attached to the tail section 1224.

Referring to Figs. 1 and 3, in one or more examples, the fuselage 1218 is an example of the object 180. The fuselage 1218 includes an exterior barrel 1230 and an interior frame 1232. In these examples, the barrel 1230 is an example of the first component 106 and the frame 1232 of is an example of the second component 110. The frame 1232 is coupled to the barrel 1230 and serves as a support structure for the fuselage 1218. It can be appreciated that, before the frame 1232 is coupled to the barrel 1230, an initial shape of the barrel 1230 may exhibit deformation 162 due to the size and weight of the barrel 1230. After the frame 1232 is coupled to the barrel 1230, the barrel 1230 may have a final shape that is different than the initial shape.

In one or more examples, the wing 1220 is an example of the object 180. The wing 1220 may also be referred to as a wing structure or a wing box. The wing 1220 includes an exterior panel assembly 1234 and an interior stiffener assembly 1236. The panel assembly 1234 includes a number of panels and may also be referred to as a wing skin. The stiffener assembly 1236 includes a number of spars, ribs, and the like. In these examples, the panel assembly 1234 is an example of the first component 106 and the stiffener assembly 1236 is an example of the second component 110. The stiffener assembly 1236 is coupled to the panel assembly 1234 and serves as a support structure for the wing 1220. It can be appreciated that, before the stiffener assembly 1236 is coupled to the panel assembly 1234, an initial shape of the panel assembly 1234 may exhibit deformation 162 due to the size and weight of the panel assembly 1234. After the stiffener assembly 1236 is coupled to the panel assembly 1234, the panel assembly 1234 may have a final shape that is different than the initial shape.

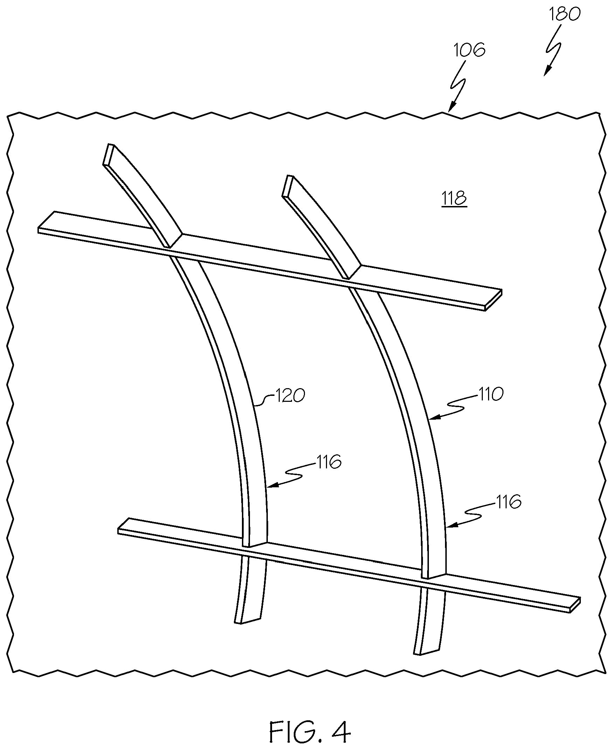

Fig. 4 illustrates an example of a portion of the object 180 formed by the first component 106 coupled to the second component 110. When the first component 106 coupled to the second component 110 are coupled together, the first mating surface 118 and the second mating surface 120 are mated. After the first component 106 coupled to the second component 110 are coupled together and the first mating surface 118 and the second mating surface 120 are mated, a number of gaps 116 may be formed between the first mating surface 118 and the second mating surface 120.

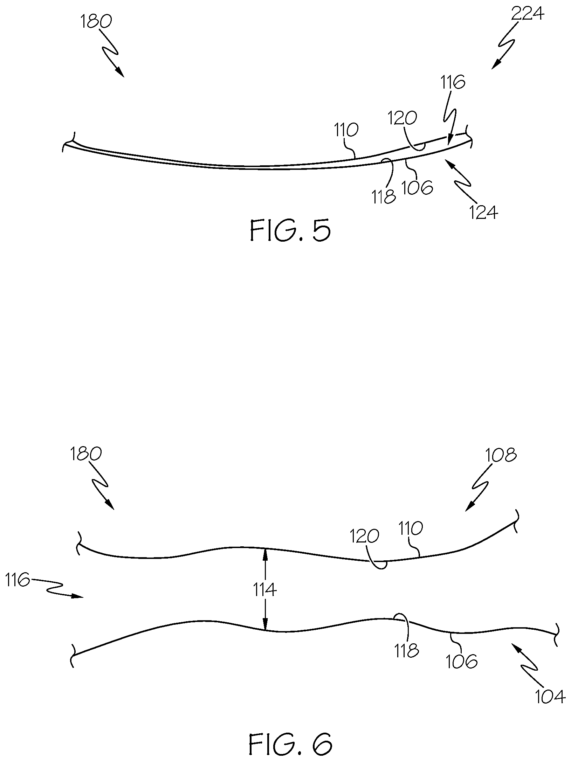

Fig. 5 graphically illustrates an example of a first nominal model 124 and a second nominal model 224 and the gap 116 formed between the first mating surface 118 and the second mating surface 120 represented by the first nominal model 124 and the second nominal model 224. In the illustrated example, the first nominal model 124 represents the first component 106, such as at least a portion of the first mating surface 118, as designed and after assembly of the object 180 (e.g., before the joining process 194). The second nominal model 224 represents the second component 110, such as at least a portion of the second mating surface 120, as designed and after assembly of the object 180 (e.g., before the joining process 194). As illustrated, the gap 116 between the first mating surface 118 and the second mating surface 120 is within (e.g., less than) the acceptable gap threshold 214 determined based on the design specifications and/or tolerances of the object 180.

Fig. 6 graphically illustrates an example of the first model 104 and the second model 108 and dimensions 114 of the gap 116 between the first mating surface 118 and the second mating surface 120 represented by the first model 104 and the second model 108. In the illustrated example, the first model 104 represents the first component 106, such as at least a portion of the first mating surface 118, as manufactured but before assembly of the object 180 (e.g., before the joining process 194). The second model 108 represents the second component 110, such as at least a portion of the second mating surface 120, as manufactured but before assembly of the object 180 (e.g., before the joining process 194). As illustrated, the gap 116 between the first mating surface 118 and the second mating surface 120 is outside (e.g., greater than) the acceptable gap threshold 214 determined based on the design specifications and/or tolerances of the object 180.

In one or more examples, the first model 104 represents the first component 106 and the first mating surface 118 in the first initial shape 174 (e.g., the shape before the joining process 194). In one or more examples, the second model 108 represents the second component 110 and the second mating surface 120 in the second initial shape 274 (e.g., the shape before the joining process 194).

As an example, the first initial shape 174 includes the first deformation 162 and the first waviness 184 in the first shape 146 (Fig. 1). For example, the first component 106 is flexible and experiences some degree of first deformation 162 (e.g., global variations in the first form 198) and the first mating surface 118 includes the first waviness 184 (e.g., local variations in the surface profile), which are represented by the first model 104.

As an example, the second initial shape 274 includes the second deformation 262 and the second waviness 284 in the second shape 246. For example, the second component 110 is flexible and experiences some degree of second deformation 262 (e.g., global variations in the second form 298) and the second mating surface 120 includes the second waviness 284 (e.g., local variations in the surface profile), which are represented by the second model 108.

As another example, the second initial shape 274 does not include the second deformation 262 and the second waviness 284 in the second shape 246. For example, the second component 110 is rigid and does not experience the second deformation 262 and the second mating surface 120 does not include the second waviness 284.

As another example, the second initial shape 274 does not include the second deformation 262 in the second shape 246 and includes the second waviness 284 in the second shape 246. For example, the second component 110 is rigid and does not experience the second deformation 262 and the second mating surface 120 includes the second waviness 284.

As illustrated in Fig. 6, the gap 116 that will be formed between the first mating surface 118 and the second mating surface 120 after the joining process 194 is represented by the space between representations of the first mating surface 118 and the second mating surface 120 in the first model 104 and the second model 108, respectively. The dimensions 114 of the gap 116 are estimated or calculated by the linear distances between the first mating surface 118 and the second mating surface 120 represented in the first model 104 and the second model 108. It can be appreciated that, in this illustrative example, the dimensions 114 of the gaps 116 indicated at this level of modelling may be larger than the dimensions 114 of the gaps 116 that will be actually present upon assembly of the object 180 (e.g., after the joining process 194).

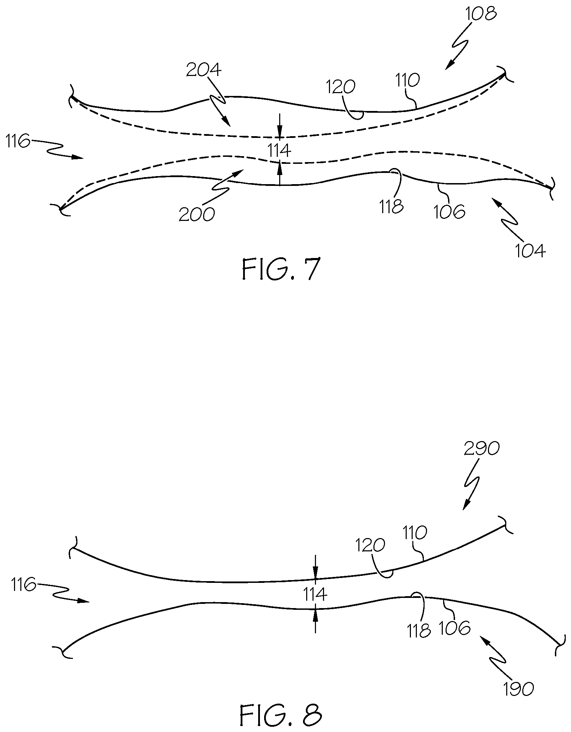

Fig. 7 graphically illustrates an example of the first model 104 and the second model 108. In one or more examples, a first space 200 between the first mating surface 118 and the second mating surface 120 represented by dashed line relative to the first model 104 represents the area or distance between the first mating surface 118 and the second mating surface 120 associated with or formed by the first deformation 162 (e.g., global variations in the first form 198) in the first shape 146 of the first component 106. Similarly, in one or more examples, a second space 204 between the first mating surface 118 and the second mating surface 120 represented by the dashed line relative to the second model 108 represents the area or distance between the first mating surface 118 and the second mating surface 120 associated with or formed by the second deformation 262 (e.g., global variations in the second form 298) in the second shape 246 of the second component 110.

Generally, the first space 200 and/or the second space 204 is closed or otherwise removed after or in response to assembly of the object 180 (e.g., after the joining process 194 of the first component 106 and the second component 110). As such, any predicted dimension 114 of the gap 116 should account for such spaces that are eliminated after assembly. Therefore, it is desirable to estimate the dimensions 114 of the gaps 116 without the first deformation 162 in the first shape 146 of the first component 106 and/or the second deformation 262 in the second shape 246 of the second component 110. The system 100 advantageously facilitates removal of the first deformation 162 and/or the second deformation 262 from the calculation of the dimensions 114 of the gaps 116 that will be formed between the first mating surface 118 and the second mating surface 120 after the first component 106 and the second component 110 are coupled together (e.g., after the joining process 194).

Fig. 8 graphically illustrates an example of an example of a first modified nominal model 190 and a second modified nominal model 290 and the dimensions 114 of the gap 116 between the first mating surface 118 and the second mating surface 120 represented by the first modified nominal model 190 and the second modified nominal model 290. In the illustrated example, the first modified nominal model 190 represents the first component 106, such as at least a portion of the first mating surface 118, as manufactured and after assembly of the object 180 (e.g., after the joining process 194). The second modified nominal model 290 represents the second component 110, such as at least a portion of the second mating surface 120, as manufactured and after assembly of the object 180 (e.g., after the joining process 194). Thus, the gap 116 predicted between the first mating surface 118 and the second mating surface 120 more accurately represents the actual gap formed between the first mating surface 118 and the second mating surface 120 after assembly of the object 180 compared to using the first nominal model 124 and the second nominal model 224 (Fig. 5) or using the first model 104 and the second model 108 (Fig. 6).

The example illustrates the analysis process used to estimate (predict) the dimensions 114 of the gaps 116 between the first mating surface 118 and the second mating surface 120, such as used in the predictive assembly process, or new proactive predictive assembly process, disclosed herein. In the illustrated example, the first deformation 162 (e.g., global variations in the first form 198) in the first shape 146 of the first component 106 and/or the second deformation 262 (e.g., global variations in the second form 298) in the second shape 246 of the second component 110 are removed from the analysis process such that only first waviness 184 in the first shape 146 of the first mating surface 118 (e.g., local variations in the surface profile) and second waviness 284 in the second shape 246 of the second mating surface 120 are accounted for when determining the dimensions 114 of the gaps 116.

As will be described in more detail herein, in one or more examples, prediction of the gap 116 is achieved by replacing the first model 104 with the first modified nominal model 190 representing the first component 106 and/or by replacing the second model 108 with the second modified nominal model 290 representing the second component 110.

In these examples, the first modified nominal model 190 represents the first component 106, such as at least a portion of the first mating surface 118. In one or more examples, the first modified nominal model 190 is the first nominal model 124 as modified by a first waviness deviation 134 extracted from the first model 104. In one or more examples, the first modified nominal model 190 represents the first component 106 and, thus, the first mating surface 118 as manufactured but after assembly of the object 180 (e.g., after the joining process 194).

The second model 108 represents the second component 110, such as at least a portion of the second mating surface 120. In one or more examples, the second modified nominal model 290 is the second nominal model 224 as modified by a second waviness deviation 234 extracted from the second model 108. The second modified nominal model 290 represents the second component 110 and, thus, the second mating surface 120 as manufactured but after assembly of the object 180 (e.g., after the joining process 194).

In one or more examples, the first modified nominal model 190 represents the first component 106 and the first mating surface 118 in the first assembled shape 176 (e.g., the final shape after the joining process 194), which, for example, does not include the first deformation 162 but does include the first waviness 184 in the first shape 146. As an example, the first deformation 162 (e.g., global variations in first form 198) in the first shape 146 of the first component 106 represented by the first space 200 (Fig. 7) has been removed (as will be pulled-out by the joining process 194) and the first mating surface 118 includes the first waviness 184 (e.g., local variations in the surface profile), which is represented by the first modified nominal model 190.

In one or more examples, the second modified nominal model 290 represents the second component 110 and the second mating surface 120 in the second assembled shape 276 (e.g., the final shape after the joining process 194), which, for example, does not include the second deformation 262 but does include the second waviness 284 in the second shape 246. As an example, the second deformation 262 (e.g., global variations in second form 298) in the second shape 246 of the second component 110 represented by the second space 204 (Fig. 7) has been removed (as will be pulled-out by the joining process 194) and the second mating surface 120 includes the second waviness 284 (e.g., local variations in the surface profile), which is represented by the second modified nominal model 290.

In other examples, the second model 108 represents the second component 110 and the second mating surface 120 in the second assembled shape 276 (e.g., the final shape after the joining process 194), which, for example, does not include the second deformation 262 and the second waviness 284 in the second shape 246. As an example, the second component 110 is rigid and does not experience second deformation 262 and the second mating surface 120 does not include second waviness 284.

The gap 116 that will be formed between the first mating surface 118 and the second mating surface 120 are represented by the space between representations of the first mating surface 118 and the second mating surface 120 in the first modified nominal model 190 and the second modified nominal model 290, respectively. In one or more examples, the dimensions 114 of the gaps 116 are estimated or calculated by the linear distances between the first mating surface 118 and the second mating surface 120 represented in the first modified nominal model 190 and the second modified nominal model 290.

It can be appreciated that, in the illustrated example of the predictive assembly process, or new proactive predictive assembly process, the dimensions 114 of the gaps 116 predicted by the process (referred to herein as predicted dimensions 188 shown in Fig. 2) are substantially equal to the dimensions 114 of the gaps 116 that will be actually present upon assembly of the object 180 (e.g., after the joining process 194). As such, a determination related to defect or nonconformance can be preemptively made based on comparing the predicted gaps 116 to the acceptable or allowable gap threshold 214.

Referring to Fig. 2, in one or more examples, the model analyzer 112 determines (e.g., is configured or adapted to determine) a first overall deviation 122 in a normal direction 150 between the first model 104 and the first nominal model 124 of the first component 106.

In one or more examples, the model analyzer 112 determines (e.g., is configured or adapted to determine) a second overall deviation 222 in the normal direction 150 between the second model 108 and the second nominal model 224 of the second component 110.

In one or more examples, the model analyzer 112 performs (e.g., is configured or adapted to perform) a best fit alignment, also referred to as a best fit analysis 186, between the first model 104 and the first nominal model 124 of the first component 106 to determine the first overall deviation 122.

In one or more examples, the model analyzer 112 performs (e.g., is configured or adapted to perform) a best fit alignment (e.g., best fit analysis 186) between the second model 108 and the second nominal model 224 of the second component 110 to determine the second overall deviation 222.

In one or more examples, the model analyzer 112 determines (e.g., is configured or adapted to determine) first overall dimensions 164 of the first overall deviation 122 in the normal direction 150.

In one or more examples, the model analyzer 112 determines (e.g., is configured or adapted to determine) second overall dimensions 264 of the second overall deviation 222 in the normal direction 150.

For the purpose of the present disclosure, the first nominal model 124 and/or the second nominal model 224 refer to a computer-aided design (CAD) model of the first component 106 and the second component 110, respectively, that represents a nominal or design geometry of the first component 106 and the second component 110 and, thus, the first mating surface 118 and the second mating surface 120, respectively. It can be appreciated that the first shape 146 of the first component 106 represented in the first nominal model 124 does not include first deformation 162 (global variations in first form 198) or first waviness 184 (local variations in surface profile). Similarly, it can be appreciated that the second shape 246 of the second component 110 represented in the second nominal model 224 does not include second deformation 262 (global variations in second form 298) or second waviness 284 (local variations in surface profile).

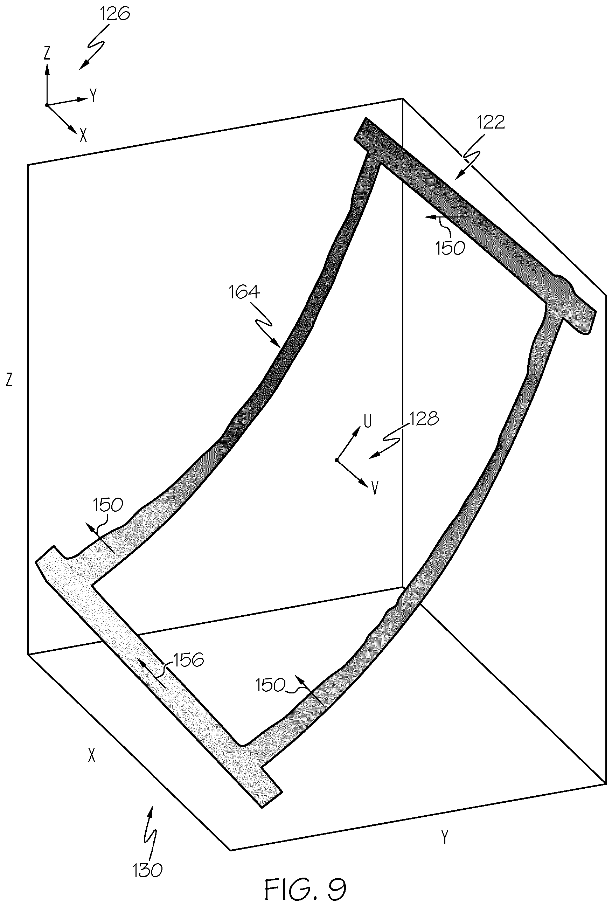

Figs. 9-12 graphically illustrate examples of the disclosed predictive assembly analysis process. The described and illustrated examples are directed to the process applied to the first component 106. However, in one or more examples, the process described and illustrated in Figs. 9-12 can be equally applied to the second component 110. Therefore, the examples described and illustrated in Figs. 9-12 are not limited in application or implementation to the first component 106. As such, reference to the "first" instance can be equally applied to the "second" instance. A complete description of application of the predictive assembly analysis process to the second component 110 has been omitted for brevity and for purposes of nonduplication and not to limit application of the process.

Fig. 9 graphically illustrates an example of the first overall deviation 122 in the normal direction 150 between the first model 104 and the first nominal model 124 the first component 106. In one or more examples, performing the best fit analysis 186, such as a least squares alignment, of the first mating surface 118 represented in the first model 104 and the first mating surface 118 represented in the first nominal model 124 provides the first overall deviation 122 in the normal direction 150 between the first model 104 (e.g., in the as-build condition) and the first nominal model 124 (e.g., the design condition). The first overall dimensions 164 are represented by or are calculated as values 130 (e.g., linear distance measurement values in the normal direction 150) relative to an XYZ-coordinate system 126.

Referring to Fig. 2, in one or more examples, the system 100, such as the computer 148, executing the instructions 170, includes a user interface (UI) 202. The graphical illustration of the first overall deviation 122 and the first overall dimensions 164 of the first overall deviation 122 depicted in Fig. 9 is an example of a graphical representation displayed to a user by the UI 202.

In one or more examples, the first overall deviation 122 includes both large-scale (e.g., gross or global) shape differences and small-scale surface variations. The large-scale shape variations represent the first form 198 and are referred to herein as first form deviations 132. The small-scale surface variations represent the first waviness 184 and are referred to herein as first waviness deviations 134. As disclosed herein, the system 100 advantageously enables the dimensions 114 of the gaps 116 that will be formed between the first mating surface 118 and the second mating surface 120 to be determined based on only the small-scale variations (the first waviness 184 and second waviness 284).

In one or more examples, the model analyzer 112 maps (e.g., is configured or adapted to map) the first overall deviation 122 from the XYZ-coordinate system 126 to a UVW-coordinate system 128 such that the values 130 for the first overall dimensions 164 of the first overall deviation 122 are represented along a W-axis 152 of the UVW-coordinate system 128. In one or more examples, coordinate mapping 192 includes any suitable conformal mapping or charting techniques.

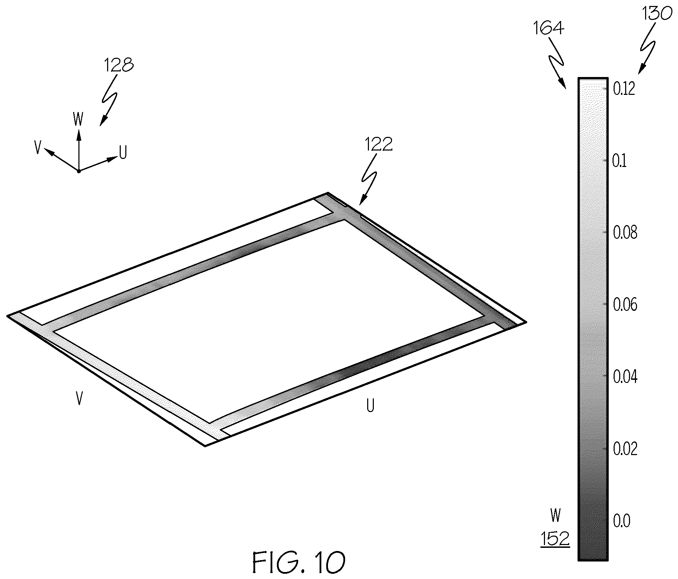

Fig. 10 graphically illustrates an example of the first overall deviation 122 as mapped from the XYZ-coordinate system 126 (Fig. 9) to the UVW-coordinate system 128. In one or more examples, the data representing the first overall deviation 122 is changed (e.g., charted or mapped) from x, y, z-coordinate points to u, v, w-coordinate points. A two-dimensional (2D) coordinate system is used so that u, v-coordinates represent location on the first component 106 and w-coordinates represent the deviations from the nominal geometry. This operation effectively removes the "designed shape" from the first component 106 so that the W-axis 152 is only deviation from the design geometry. The graphical illustration of the first overall deviation 122 and the first overall dimensions 164 of the first overall deviation 122 depicted in Fig. 10 is an example of a graphical representation displayed to a user by the UI 202.

Referring to Fig. 2, in one or more examples, the model analyzer 112 filters (e.g., is configured or adapted to filter) the values 130 for the first overall dimensions 164 of the first overall deviation 122 into the first form deviation 132 and the first waviness deviation 134. In one or more examples, the system 100, such as the computer 148, executing the instructions 170, includes a filter 154 that performs the filtering process. In one or more examples, the model analyzer 112 filters the values 130 using a low-pass filter 156. In one or more examples, the model analyzer 112 filters the values 130 using a robust Gaussian regression filter 158. In one or more examples, the filter 154, such as the low-pass filter 156 or the robust Gaussian regression filter 158, is run over the (u, v, w-point cloud to filter the data into first form 198 and first waviness 184. Because the designed curvature has effectively been removed, a first order regression function (e.g., planar regression) is selected and used for the local fitting.

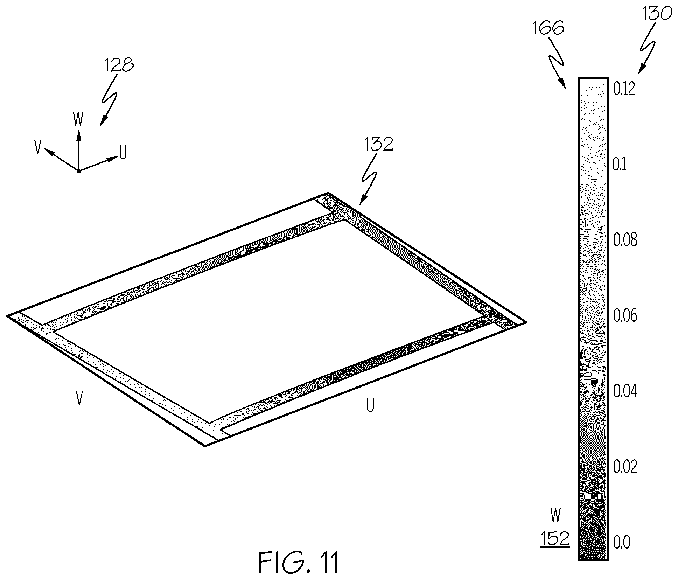

Fig. 11 graphically illustrates an example of the first form deviation 132 and the values 130 of the first form dimensions 166 as mapped to the UVW-coordinate system 128 and as filtered from the first overall dimensions 164 of the first overall deviation 122. As depicted in the illustrative example, the values 130 of the first form dimensions 166 of the first form deviation 132 (Fig. 11) are approximately equal to the values 130 of the first overall dimensions 164 of the first overall deviation 122 (Fig. 10). This is because the global variations in the first form 198 (first form deviation 132) due to the first deformation 162 represent the majority of the first overall deviation 122 from the design geometry. The graphical illustration of the first form deviation 132 and the first form dimensions 166 of the first form deviation 132 depicted in Fig. 11 is an example of a graphical representation displayed to a user by the UI 202.

A substantially similar operation and example can be used to for the second form deviation 232 and the values 130 of the second form dimensions 266 as mapped to the UVW-coordinate system 128 and as filtered from the second overall dimensions 264 of the second overall deviation 222.

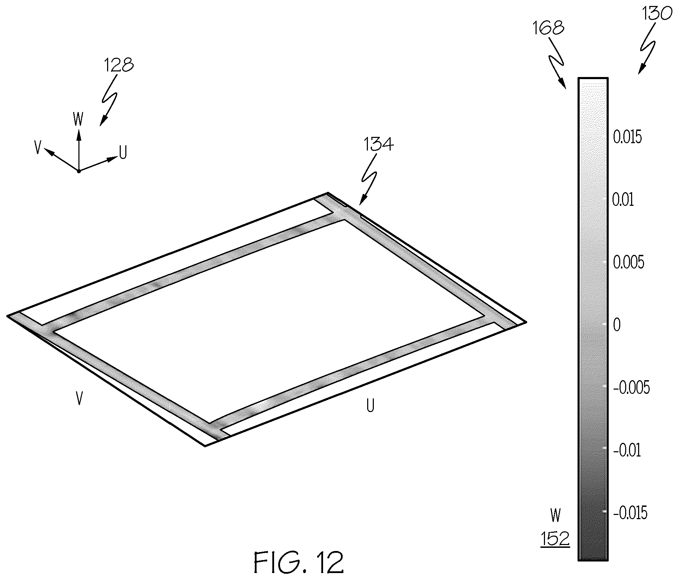

Fig. 12 graphically illustrates an example of the first waviness deviation 134 and the values 130 of the first waviness dimensions 168 as mapped to the UVW-coordinate system 128 and as filtered from the first overall dimensions 164 of the first overall deviation 122. As depicted in the illustrative example, the values 130 of the first waviness dimensions 168 of the first waviness deviation 134 (Fig. 12) are orders of magnitude less than the values 130 of the first overall dimensions 164 of the first overall deviation 122 (Fig. 10). This is because the local variations in the first waviness 184 (first waviness deviation 134) due to small-scale variations in the surface profile of the first mating surface 118 represent a small portion of the first overall deviation 122 from the design geometry. The graphical illustration of the first waviness deviation 134 and the first waviness dimensions 168 of the first waviness deviation 134 depicted in Fig. 12 is an example of a graphical representation displayed to a user by the UI 202.

Referring again to Fig. 2, in one or more examples, the model analyzer 112 modifies (e.g., is configured or adapted to modify) the first nominal model 124 by the first waviness deviation 134. The first nominal model 124, as modified by the first waviness deviation 134, represents the first mating surface 118 of the first component 106 after the first component 106 and the second component 110 are coupled together. The first nominal model 124 as modified by the first waviness deviation 134 is also referred to herein as the first modified nominal model 190. In one or more examples, the model analyzer 112 maps (e.g., is configured or adapted to map) the first waviness deviation 134 from the UVW-coordinate system 128 to the XYZ-coordinate system 126 such that values 130 for first waviness dimensions 168 of the first waviness deviation 134 are represented as first distances 160 relative to the first nominal model 124.

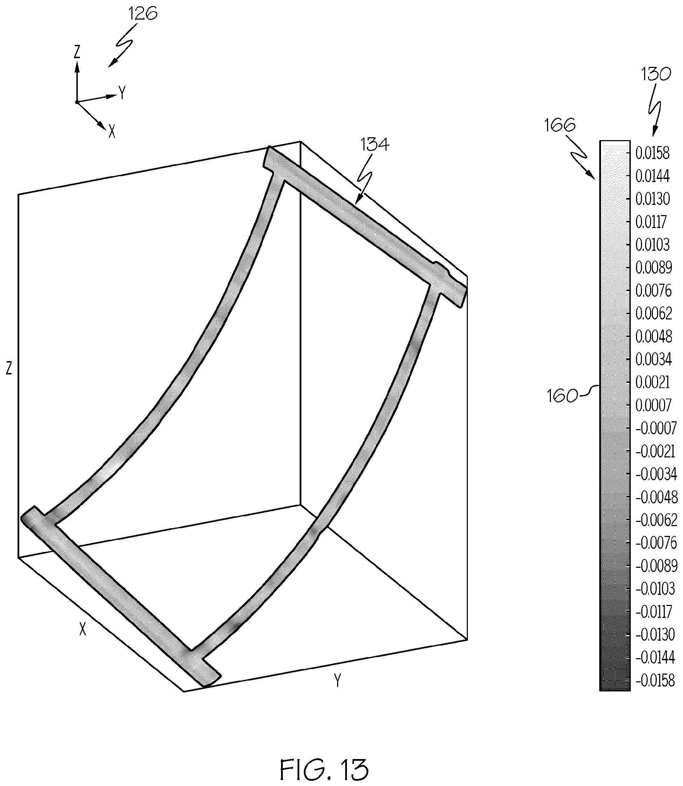

Fig. 13 graphically illustrates an example of the first waviness deviation 134 as mapped from the UVW-coordinate system 128 (Fig. 12) back to the XYZ-coordinate system 126 and the values 130 of the first waviness dimensions 168 represented as first distances 160 in the normal direction 150 relative to the first nominal model 124. In one or more examples, the data representing the first waviness deviation 134 is changed (e.g., charted or mapped) from u, v, w-coordinate points back to x, y, z-coordinate points. The calculated first waviness 184 in the w-coordinate is used as the first distance 160 to add to the first nominal model 124 or to subtract from the first nominal model 124 to estimate one or more dimensions 114 of one or more gaps 116 that will be formed between the first mating surface 118 and the second mating surface 120 after the first component 106 and the second component 110 are coupled together (e.g., after the joining process 194). The graphical illustration of the first waviness deviation 134 and the first waviness dimensions 168 as the first distances 160 depicted in Fig. 13 is an example of a graphical representation displayed to a user by the UI 202.

Referring again to Fig. 2, in one or more examples, the system 100 includes a measurement system 136. The measurement system 136 generates first data 138 representing at least a portion of the first mating surface 118 of the first component 106 and/or used for the first model 104. The measurement system 136 generates second data 140 representing at least a portion of the second mating surface 120 of the second component 110 and/or used for the second model 108. The first data 138 and the second data 140 are generated before the first component 106 and the second component 110 are coupled together and the first mating surface 118 and the second mating surface 120 are mated.

In one or more examples, the measurement system 136 includes or takes the form of a scanning device that is used to scan the first component 106, such as at least a portion of the first mating surface 118, and to generate the first data 138. The measurement system 136 includes or takes the form of a scanning device that is used to scan the second component 110, such as at least a portion of the second mating surface 120, and to generate the second data 140. The scanning device may take the form of, for example, without limitation, a laser system, an optical measurement device, or some other type of system. The laser system may be, for example, a laser radar scanner. The optical measurement device may be, for example, a three-dimensional optical measurement device. In another illustrative example, measurement system 136 takes the form of a photogrammetry system.

In one or more examples, the first component 106 and the second component 110 may be manufactured in different locations and/or measured (e.g., scanned) in different locations. As such, in one or more examples, the measurement system 136 includes more than one scanning device, in which each one of the scanning devices is co-located with or is dedicated to the manufacturing or measuring environment associated with a respective one of the first component 106 and the second component 110.

Referring to Figs. 1 and 2, in one or more examples, the first data 138 includes data or 3D shape information about the first shape 146, for example, the first initial shape 174, of the first component 106 and, thus, the first mating surface 118. In one or more examples, the second data 140 includes data or 3D shape information about the second shape 246, for example, the second initial shape 274, of the second component 110 and, thus, the second mating surface 120.

Referring to Fig. 2, in one or more examples, the first data 138 and the second data 140 take the form of three-dimensional point clouds. As an example, the first data 138 takes the form of a first three-dimensional point cloud that has sufficient density to capture the first shape 146 of the first component 106 and, thus, the first mating surface 118 with a desired level of accuracy. Similarly, the second data 140 takes the form of a second three-dimensional point cloud that has sufficient density to capture the second shape 246 of the second component 110 and, thus, the second mating surface 120 with a desired level of accuracy.

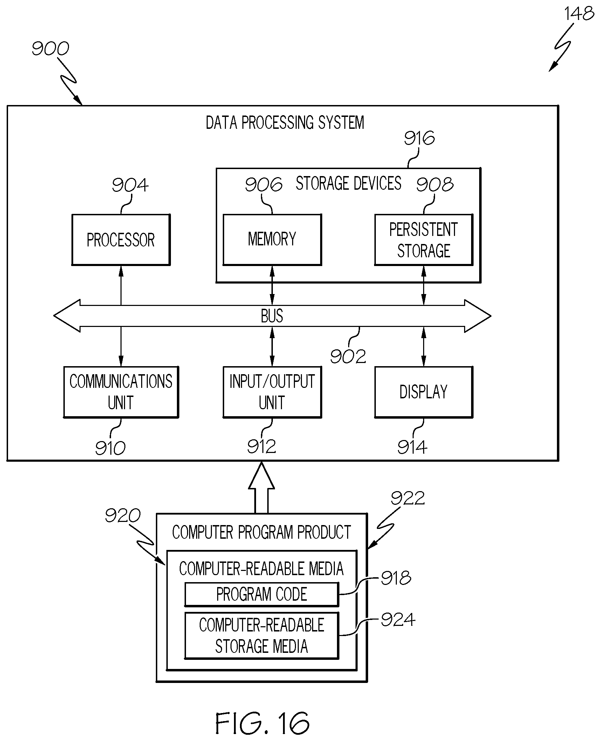

Referring to Figs. 2 and 16, in one or more examples, the model generator 102, the model analyzer 112, and the assembly planner 210 take the form of program code 918 that is executed by a data processing system 900.

Referring now to Figs. 1-13, the following are examples of the system 100, according to the present disclosure. The system 100 includes a number of elements, features, and components. Not all of the elements, features, and/or components described or illustrated in one example are required in that example. Some or all of the elements, features, and/or components described or illustrated in one example can be combined with other examples in various ways without the need to include other elements, features, and/or components described in those other examples, even though such combination or combinations are not explicitly described or illustrated by example herein.

In one or more examples, the system 100 includes the model generator 102, the model analyzer 112, and the assembly planner 210. The model generator 102 generates the first model 104 of the first component 106 and the second model 108 of the second component 110 before the first component 106 and the second component 110 are coupled together.

In one or more examples, the model analyzer 112 analyzes the first model 104 and the second model 108 to determine the dimension 114 of the gap 116 between the first mating surface 118 of the first component 106 and the second mating surface 120 of the second component 110 after the first component 106 and the second component 110 are coupled together.

In one or more examples, the model analyzer 112 filters out the first deformation 162 of the first component 106 and/or the second deformation 262 of the second component 110 before the first component 106 and the second component 110 are coupled together. The model analyzer 112 also determines (e.g., calculates a prediction for) the dimension 114 of the gap 116 between the first mating surface 118 of the first component 106 and the second mating surface 120 of the second component 110.

In one or more examples, the assembly planner 210 recommends the action 212 based on a comparison of the gap 116 to the gap threshold 214. In one or more examples, the assembly planner 210 recommends the action 212 based on the dimension 114 of the gap 116.

In one or more examples, when the dimension 114 of the gap 116 is less than or equal to the gap threshold 214, the action 212 recommended by the assembly planner 210 includes coupling the first component 106 and the second component 110 together. In one or more examples, when the dimension 114 of the gap 116 is greater than the gap threshold 214, the action 212 recommended by the assembly planner 210 includes at least one of: reprocessing at least one of the first component 106 and the second component 110; redesigning at least one of the first component 106 and the second component 110 when the dimension 114 of the gap 116 is greater than the gap threshold 214; and repairing at least one of the first component 106 and the second component 110 when the dimension 114 of the gap 116 is greater than the gap threshold 214.

In one or more examples, the model analyzer 112 modifies the first nominal model 124 of the first component 106 by the first waviness deviation 134. The model analyzer 112 modifies the second nominal model 224 of the second component 110 by the second waviness deviation 234. The first modified nominal model 190 represents the first mating surface 118 of the first component 106 after the first component 106 and the second component 110 are coupled together. The second modified nominal model 290 represents the second mating surface 120 of the second component 110 after the first component 106 and the second component 110 are coupled together. The dimension 114 of the gap 116 is determined using the first modified nominal model 190 and the second modified nominal model 290.

In one or more examples, the model analyzer 112 determines the first overall deviation 122 in a normal direction between the first model 104 and the first nominal model 124 of the first component 106. The model analyzer 112 determines the second overall deviation 222 in a normal direction between the second model 108 and the second nominal model 224 of the second component 110. The first waviness deviation 134 is derived from the first overall deviation 122. The second waviness deviation 234 is derived from the second overall deviation 222.

In one or more examples, the model analyzer 112 performs a best fit alignment between the first model 104 and the first nominal model 124 of the first component 106 to determine the first overall deviation 122. The model analyzer 112 performs the best fit alignment between the second model 108 and the second nominal model 224 of the second component 110 to determine the second overall deviation 222.

In one or more examples, the model analyzer 112 determines the first overall dimension 164 of the first overall deviation 122 in the normal direction. The model analyzer 112 determines the second overall dimension 264 of the second overall deviation 222 in the normal direction.

In one or more examples, the model analyzer 112 maps the first overall deviation 122 from the XYZ-coordinate system 126 to the UVW-coordinate system 128 such that first values for the first overall dimensions 164 of the first overall deviation 122 are represented along the W-axis 152. In one or more examples, the model analyzer 112 maps the second overall deviation 222 from the XYZ-coordinate system 126 to the UVW-coordinate system 128 such that second values for the second overall dimensions 264 of the second overall deviation 222 are represented along the W-axis 152.

In one or more examples, the model analyzer 112 filters the first values for the first overall dimensions 164 of the first overall deviation 122 into the first form deviation 132 and the first waviness deviation 134. In one or more examples, the model analyzer 112 filters the second values for the second overall dimensions 264 of the second overall deviation 222 into a second form deviation 232 and the second waviness deviation 234.

In one or more examples, the model analyzer 112 maps the first waviness deviation 134 from the UVW-coordinate system 128 to the XYZ-coordinate system 126 such that first values for first waviness dimensions 168 of the first waviness deviation 134 are represented as first distances 160 relative to the first nominal model 124. In one or more examples, the model analyzer 112 maps the second waviness deviation 234 from the UVW-coordinate system 128 to the XYZ-coordinate system 126 such that second values for second waviness dimensions 268 of the second waviness deviation 234 are represented as second distances 260 relative to the second nominal model 224.

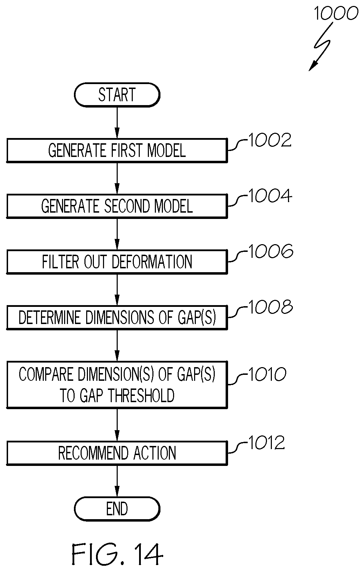

Referring now to Fig. 14, in one or more examples, the method 1000 includes a step of generating 1002 the first model 104 of the first component 106. The method 1000 includes a step of generating 1004 the second model 108 of the second component 110. The step of generating 1002 the first model 104 and the step of generating 1004 the second model 108 are performed before the first component 106 and the second component 110 are coupled together. The method 1000 includes a step of filtering 1006 out the first deformation 162 of the first component 106 and the second deformation 262 of the second component 110 existing before the first component 106 and the second component 110 are coupled together. The method 1000 includes a step of determining (e.g., predicting) 1008 the dimension 114 of the gap 116 that will exist between the first mating surface 118 and the second mating surface 120 after the first component 106 and the second component 110 are coupled together. The method 1000 includes a step of comparing 1010 the dimension 114 of the gap 116 to the gap threshold 214. The method 1000 includes a step of recommending 1012 the action 212 based on the prediction of the dimension 114 of the gap 116.

In one or more examples, the step of filtering 1006 out the deformation of at least one of the first component 106 and the second component 110 before the first component 106 and the second component 110 are coupled together is an example of analyzing the first model 104 and the second model 108 of disclosed predictive assembly analysis process (e.g., method 2000).

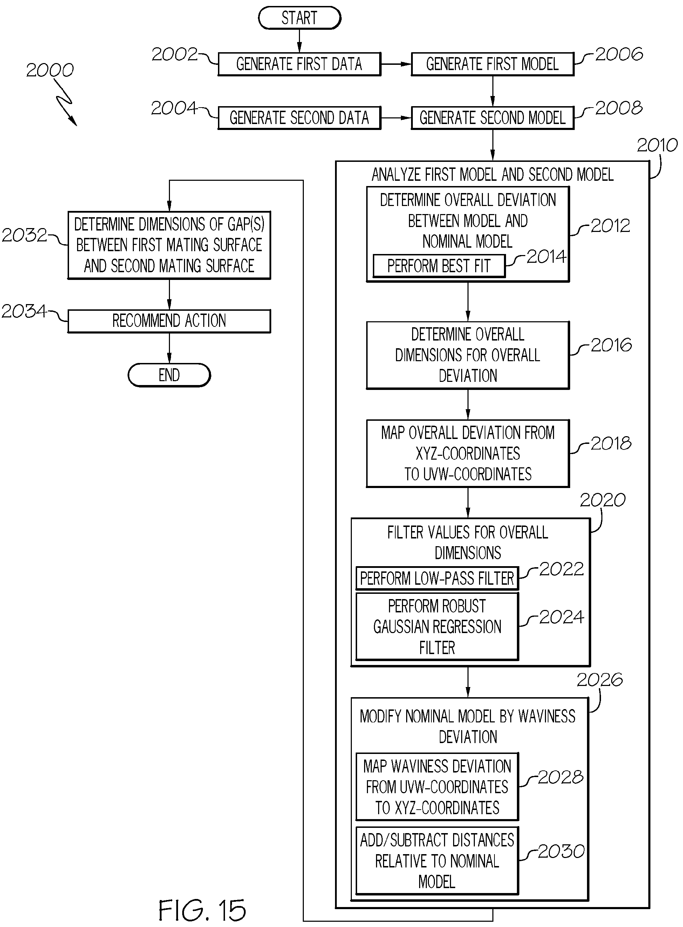

Referring now to Fig. 15, in one or more examples, the method 2000 includes a step of generating 2006 the first model 104 of the first component 106. The method 2000 includes a step of generating 2008 the second model 108 of the second component 110. The step of generating 2006 the first model 104 and the step of generating 2008 the second model 108 are performed before the first component 106 and the second component 110 are coupled together.

In one or more examples, the method 2000 includes a step of analyzing 2010 the first model 104 and the second model 108 to determine the dimension 114 of the gap 116 between the first mating surface 118 of the first component 106 and the second mating surface 120 of the second component 110 after the first component 106 and the second component 110 are coupled together. As an example, the method 2000 includes a step of determining 2032 (e.g., calculating) the dimension 114 of the gap 116 between the first mating surface 118 of the first component 106 and the second mating surface 120 of the second component 110 based on the analysis performed on the first model 104 and the second model 108.

In one or more examples, the method 2000, such as the step of analyzing 2010, includes a step of determining 2012 (e.g., calculating) the first overall deviation 122 in the normal direction 150 between the first model 104 and the first nominal model 124 of the first component 106. In one or more examples, the step of analyzing 2010 also includes a step of determining 2012 (e.g., calculating) the second overall deviation 222 in the normal direction 150 between the second model 108 and the second nominal model 224 of the second component 110.

In one or more examples, the method 2000, such as the step of determining 2012, includes a step of performing 2014 a best fit alignment between the first model 104 and the first nominal model 124 of the first component 106 to determine the first overall deviation 122. In one or more examples, the step of determining 2012 includes a step of performing 2014 a best fit alignment between the second model 108 and the second nominal model 224 of the second component 110 to determine the second overall deviation 222.

In one or more examples, the method 2000, such as the step of analyzing 2010, includes a step of determining 2016 (e.g., calculating) the first overall dimensions 164 of the first overall deviation 122 in the normal direction 150. In one or more examples, the step of analyzing 2010 includes a step of determining 2016 (e.g., calculating) the second overall dimensions 264 of the second overall deviation 222 in the normal direction 150.

In one or more examples, the method 2000, such as the step of analyzing 2010, includes a step of mapping 2018 the first overall deviation 122 from the XYZ-coordinate system 126 to the UVW-coordinate system 128 such that values for the first overall dimensions 164 of the first overall deviation 122 are represented along the W-axis 152. In one or more examples, the step of analyzing 2010 includes a step of mapping 2018 the second overall deviation 222 from the XYZ-coordinate system 126 to the UVW-coordinate system 128 such that values for the second overall dimensions 264 of the second overall deviation 222 are represented along the W-axis 152.

In one or more examples, the method 2000, such as the step of analyzing 2010, includes a step of filtering 2020 the values for the first overall dimensions 164 of the first overall deviation 122 into the first form deviation 132 and the first waviness deviation 134. In one or more examples, the step of analyzing 2010 includes a step of filtering 2020 the values for the second overall dimensions 264 of the second overall deviation 222 into the second form deviation 232 and the second waviness deviation 234.

In one or more examples, according to the method 2000, the step of filtering 2020 is performed using the low-pass filter 156 or includes a step of performing 2022 or executing the low-pass filter 156. In one or more examples, according to the method 1000, the step of filtering 2020 is performed using the robust Gaussian regression filter 158 or includes a step of performing 2024 or executing the robust Gaussian regression filter 158.

In one or more examples, the method 2000, such as the step of analyzing 2010, includes a step of modifying 2026 the first nominal model 124 by the first waviness deviation 134 such that the first nominal model 124, as modified by the first waviness deviation 134, represents the first mating surface 118 of the first component 106 after the first component 106 and the second component 110 are coupled together. In one or more examples, the step of analyzing 2010 includes a step of modifying 2026 the second nominal model 224 by the second waviness deviation 234 such that the second nominal model 224, as modified by the second waviness deviation 234, represents the second mating surface 120 of the second component 110 after the first component 106 and the second component 110 are coupled together.

In one or more examples, the dimension 114 of the gap 116 is determined using the first modified nominal model 190 and the second modified nominal model 290.

In one or more examples, the method 2000, such as the step of modifying 2026, includes a step of mapping 2028 the first waviness deviation 134 from the UVW-coordinate system 128 to the XYZ-coordinate system 126 such that values for first waviness dimensions 168 of the first waviness deviation 134 are represented as first distances 160 relative to the first nominal model 124. In one or more examples, the step of modifying 2026 includes a step of mapping 2028 the second waviness deviation 234 from the UVW-coordinate system 128 to the XYZ-coordinate system 126 such that values for second waviness dimensions 268 of the second waviness deviation 234 are represented as second distances 260 relative to the second nominal model 224.

In one or more examples, the step of modifying 2026 includes a step of adding 2030 the first distances 160 to and/or subtracting 2030 the first distances 160 from the first nominal model 124 such that the first modified nominal model 190 represents the first component 106 having the first assembled shape 176, thereby providing at least a portion of the dimensions 114 of the gaps 116. In one or more examples, the step of modifying 2026 includes a step of adding 2030 the second distances 260 to and/or subtracting 2030 the second distances 260 from the second nominal model 224 such that the second modified nominal model 290 represents the second component 110 having the second assembled shape 276, thereby providing at least a portion of the dimensions 114 of the gaps 116.

In one or more examples, the method 2000 includes a step of generating 2002 first data 138 representing at least a portion of the first mating surface 118 of the first component 106. The step of generating 2002 the first data 138 is performed before the first component 106 and the second component 110 are coupled together. The first model 104 is generated using the first data 138.

In one or more examples, the method 1000 includes a step of generating 2004 second data 140 representing at least a portion of the second mating surface 120 of the second component 110. The step of generating 2004 the second data 140 is performed before the first component 106 and the second component 110 are coupled together. The second model 108 is generated using the second data 140.

in one or more examples, the method 1000 includes a step of recommending 2034 the action 212 based on a comparison of the gap 116 (e.g., dimensions 114) to the gap threshold 214. In one or more examples, the action 212 includes coupling the first component 106 and the second component 110 together when the dimension 114 of the gap 116 is less than or equal to the gap threshold 214. In one or more examples, the action 212 includes reprocessing at least one of the first component 106 and the second component 110 when the dimension 114 of the gap 116 is greater than the gap threshold 214. In one or more examples, the action 212 includes redesigning at least one of the first component 106 and the second component 110 when the dimension 114 of the gap 116 is greater than the gap threshold 214. In one or more examples, the action 212 comprises repairing at least one of the first component 106 and the second component 110 when the dimension 114 of the gap 116 is greater than the gap threshold 214.

In one or more examples, the method 1000 includes a step of coupling the first component 106 and the second component 110 together. In one or more examples, the step of coupling is performed using the joining process 194 such that the first mating surface 118 and the second mating surface 120 are mated. In one or more examples, a number of the gaps 116 are formed between the first mating surface 118 and the second mating surface 120. In these examples, the dimensions 114 of the gaps 116 are less than the gap threshold 214 such that the object satisfies assembly and/or gap requirements according to the design, specification, and/or tolerance.

Referring to Figs. 2, 14 and 15, in one or more examples, the method 1000 and/or the method 2000 is implemented using the computer 148. For example, the method 1000 and/or the method 2000 is a computer-implemented method. In one or more examples, the system 100 is a computer-implemented system that is configured or adapted to implement the method 1000 and/or the method 2000.

Referring to Fig. 3, also disclosed is a portion of the aircraft 1200. The portion of the aircraft 1200 is fabricated using the system 100 and/or according to the method 1000 or the method 2000.

Referring to Fig. 16, by way of examples, the present disclosure is also directed to the computer program product 922. The computer program product 922 includes a computer-readable medium 920 which may be non-transitory, including program code 918 that, when executed by one or more processors 904, causes the one or more processors 904 to perform operations.

In one or more examples, the operations include generating the first model 104 of the first component 106 from the first data 138 before the first component 106 is coupled to the second component 110. The operations include generating the second model 108 of the second component 110 from the second data 140 before the second component 110 is coupled to the first component 106.

In one or more examples, the operations include filtering out the first deformation 162. In one or more examples, the operations include filtering out the second deformation 262.

In one or more examples, the operations include analyzing the first model 104 and the second model 108 to determine dimensions 114 of the gap 116 between the first mating surface 118 of the first component 106 and the second mating surface 120 of the second component 110 after the first component 106 and the second component 110 are coupled together.

In one or more examples, the operations include determining the first overall deviation 122 in the normal direction 150 between the first model 104 and the first nominal model 124 of the first component 106. In one or more examples, the operations include determining the second overall deviation 222 in the normal direction 150 between the second model 108 and the second nominal model 224 of the second component 110.

In one or more examples, the operations include performing the best fit alignment between the first model 104 and the first nominal model 124 of the first component 106 to determine the first overall deviation 122. In one or more examples, the operations include performing the best fit alignment between the second model 108 and the second nominal model 224 of the second component 110 to determine the second overall deviation 222.

In one or more examples, the operations include determining first overall dimensions 164 of the first overall deviation 122 in the normal direction 150. In one or more examples, the operations include determining second overall dimensions 264 of the second overall deviation 222 in the normal direction 150.

In one or more examples, the operations include mapping the first overall deviation 122 from the XYZ-coordinate system 126 to the UVW-coordinate system 128 such that values for the first overall dimensions 164 of the first overall deviation 122 are represented along the W-axis 152. In one or more examples, the operations include mapping the second overall deviation 222 from the XYZ-coordinate system 126 to the UVW-coordinate system 128 such that values for the second overall dimensions 264 of the second overall deviation 222 are represented along the W-axis 152.

In one or more examples, the operations include filtering the values for the first overall dimensions 164 of the first overall deviation 122 into the first form deviation 132 and the first waviness deviation 134. In one or more examples, the operations include filtering the values for the second overall dimensions 264 of the second overall deviation 222 into the second form deviation 232 and the second waviness deviation 234.

In one or more examples, the filtering is performed using the low-pass filter 156. In one or more examples, the filtering is performed using the robust Gaussian regression filter 158.

In one or more examples, the operations include mapping the first waviness deviation 134 from the UVW-coordinate system 128 to the XYZ-coordinate system 126 such that values for the first waviness dimensions 168 of the first waviness deviation 134 are represented as first distances 160 relative to the first nominal model 124. In one or more examples, the operations include mapping the second waviness deviation 234 from the UVW-coordinate system 128 to the XYZ-coordinate system 126 such that values for the second waviness dimensions 268 of the second waviness deviation 234 are represented as second distances 260 relative to the second nominal model 224.

In one or more examples, the operations include modifying the first nominal model 124 by the first waviness deviation 134 (e.g., first distances 160) such that the first nominal model 124 as modified by the first waviness deviation 134 (e.g., first modified nominal model 190) represents the first mating surface 118 of the first component 106 after the first component 106 and the second component 110 are coupled together. In one or more examples, the operations include modifying the second nominal model 224 by the second waviness deviation 234 (e.g., second distances 260) such that the second nominal model 224 as modified by the second waviness deviation 234 (e.g., second modified nominal model 290) represents the second mating surface 120 of the second component 110 after the first component 106 and the second component 110 are coupled together.

In one or more examples, the operations include analyzing the first modified nominal model 190 and the second modified nominal model 290 to determine the dimension 114 of the gap 116 between the first mating surface 118 of the first component 106 and the second mating surface 120 of the second component 110 after the first component 106 and the second component 110 are coupled together.

In one or more examples, the operations include recommending the action 212 based on a comparison of the gap 116 to the gap threshold 214. In one or more examples, the action 212 includes coupling the first component 106 and the second component 110 together when the dimension 114 of the gap 116 is less than or equal to the gap threshold 214. In one or more examples, the action 212 includes reprocessing at least one of the first component 106 and the second component 110 when the dimension 114 of the gap 116 is greater than the gap threshold 214. In one or more examples, the action 212 includes redesigning at least one of the first component 106 and the second component 110 when the dimension 114 of the gap 116 is greater than the gap threshold 214. In one or more examples, the action 212 includes repairing at least one of the first component 106 and the second component 110 when the dimension 114 of the gap 116 is greater than the gap threshold 214.

Referring to Fig. 2, in one or more examples, the system 100 may be implemented using software, hardware, firmware, or a combination thereof. When software is used, the operations performed by the system 100 may be implemented using, for example, without limitation, program code configured to run on a processor unit. When firmware is used, the operations performed by the system 100 may be implemented using, for example, without limitation, program code and data and stored in persistent memory to run on a processor unit.

When hardware is employed, the hardware may include one or more circuits that operate to perform the operations performed by the system 100. Depending on the implementation, the hardware may take the form of a circuit system, an integrated circuit, an application specific integrated circuit (ASIC), a programmable logic device, or some other suitable type of hardware device configured to perform any number of operations.

A programmable logic device may be configured to perform certain operations. The device may be permanently configured to perform these operations or may be reconfigurable. A programmable logic device may take the form of, for example, without limitation, a programmable logic array, a programmable array logic, a field programmable logic array, a field programmable gate array, or some other type of programmable hardware device.

In some illustrative examples, the operations and processes performed by the system 100 may be performed using organic components integrated with inorganic components. In some cases, the operations and processes may be performed by entirely organic components, excluding a human being. For example, circuits in organic semiconductors may be used to perform these operations and processes.

Referring to Fig. 16, in one or more examples, the computer 148 (Fig. 2) includes or takes the form of a data processing system 900. In one or more examples, the data processing system 900 includes a communications framework 902, which provides communications between at least one processor 904, one or more storage devices 916, such as memory 906 and/or persistent storage 908, a communications unit 910, an input/output unit 912 (I/O unit), and a display 914. In this example, the communications framework 902 takes the form of a bus system.

The processor 904 serves to execute the instructions 170 (Fig. 2) for software that can be loaded into the memory 906. In one or more examples, the processor 904 is a number of processor units, a multi-processor core, or some other type of processor, depending on the particular implementation.

The memory 906 and the persistent storage 908 are examples of the storage devices 916. A storage device is any piece of hardware that is capable of storing information, such as, for example, without limitation, at least one of data, program code in functional form, or other suitable information either on a temporary basis, a permanent basis, or both on a temporary basis and a permanent basis. The storage devices 916 may also be referred to as computer readable storage devices in one or more examples. The memory 906 is, for example, a random-access memory or any other suitable volatile or non-volatile storage device. The persistent storage 908 can take various forms, depending on the particular implementation.

For example, the persistent storage 908 contains one or more components or devices. For example, the persistent storage 908 is a hard drive, a solid-state hard drive, a flash memory, a rewritable optical disk, a rewritable magnetic tape, or some combination of the above. The media used by the persistent storage 908 also can be removable. For example, a removable hard drive can be used for the persistent storage 908.

The communications unit 910 provides for communications with other systems or devices, such as the measurement system 136 or other computer systems. In one or more examples, the communications unit 910 is a network interface card.

Input/output unit 912 allows for input and output of data with other devices that can be connected to the data processing system 900. As an example, the input/output unit 912 provides a connection for user input through at least one of a keyboard, a mouse, or some other suitable input device. Further, the input/output unit 912 can send output to a printer. The display 914 provides a mechanism to display information to a user. For example, the user interface 202 is displayed to a user by the display 914.

Instructions (e.g., instructions 170) for at least one of the operating system, applications, or programs can be located in the storage devices 916, which are in communication with the processor 904 through the communications framework 902. The processes of the various examples and operations described herein can be performed by the processor 904 using computer-implemented instructions, which can be located in a memory, such as the memory 906.

The instructions 170 are referred to as program code, computer usable program code, or computer readable program code that can be read and executed by a processor of the processor 904. The program code in the different examples can be embodied on different physical or computer readable storage media, such as the memory 906 or the persistent storage 908.

In one or more examples, the program code 918 is located in a functional form on computer readable media 920 that is selectively removable and can be loaded onto or transferred to the data processing system 900 for execution by the processor 904. In one or more examples, the program code 918 and computer readable media 920 form the computer program product 922. In one or more examples, the computer readable media 920 is computer readable storage media 924.

In one or more examples, the computer readable storage media 924 is a physical or tangible storage device used to store the program code 918 rather than a medium that propagates or transmits the program code 918.

Alternatively, the program code 918 can be transferred to the data processing system 900 using a computer readable signal media. The computer readable signal media can be, for example, a propagated data signal containing the program code 918. For example, the computer readable signal media can be at least one of an electromagnetic signal, an optical signal, or any other suitable type of signal. These signals can be transmitted over at least one of communications links, such as wireless communications links, optical fiber cable, coaxial cable, a wire, or any other suitable type of communications link.

The different components illustrated for data processing system 900 are not meant to provide architectural limitations to the manner in which different examples can be implemented. The different examples can be implemented in a data processing system including components in addition to or in place of those illustrated for the data processing system 900. Other components shown in Fig. 16 can be varied from the examples shown. The different examples can be implemented using any hardware device or system capable of running the program code 918.

Additionally, various components of the computer 148 and/or the data processing system 900 may be described as modules. For the purpose of the present disclosure, the term "module" includes hardware, software or a combination of hardware and software. As an example, a module can include one or more circuits configured to perform or execute the described functions or operations of the executed processes described herein (e.g., the method 1000 and/or the method 2000). As another example, a module includes a processor, a storage device (e.g., a memory), and computer-readable storage medium having instructions that, when executed by the processor causes the processor to perform or execute the described functions and operations. In one or more examples, a module takes the form of the program code 918 and the computer readable media 920 together forming the computer program product 922. In one or more examples, the model generator 102, the model analyzer 112, and/or the assembly planner 210 are implemented as modules.

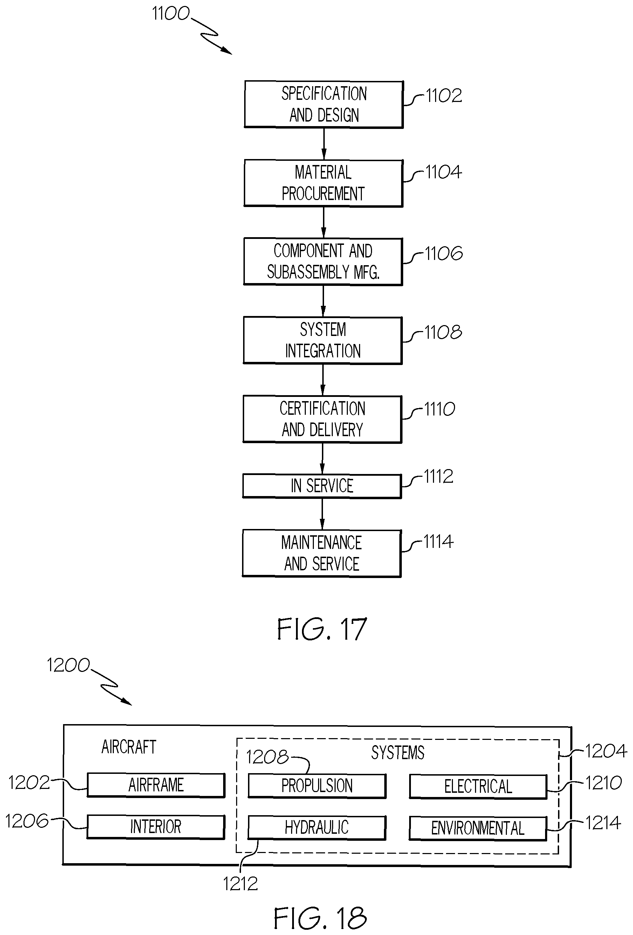

Referring now to Figs. 17 and 18, examples of the system 100, the method 1000, the method 2000, and/or the computer program product 922 described herein, may be related to, or used in the context of, an aircraft manufacturing and service method 1100, as shown in the flow diagram of Fig. 17 and the aircraft 1200, as schematically illustrated in Figs. 3 and 18. For example, the aircraft 1200 and/or the aircraft production and service method 1100 may include the object 180 (Fig. 1), such as the fuselage 1218, the wings 1220, and the like, made using the system 100 and/or according to the method 1000 or the method 2000.

Referring to Fig. 3 and 18, which illustrates examples of the aircraft 1200. The aircraft 1200 includes an airframe 1202 having an interior 1206. The aircraft 1200 includes a plurality of onboard systems 1204 (e.g., high-level systems). Examples of the onboard systems 1204 of the aircraft 1200 include propulsion systems 1208, hydraulic systems 1212, electrical systems 1210, and environmental systems 1214. In other examples, the onboard systems 1204 also includes one or more control systems 1216 coupled to an airframe 1202 of the aircraft 1200, such as for example, flaps, spoilers, ailerons, slats, rudders, elevators, and trim tabs. In yet other examples, the onboard systems 1204 also includes one or more other systems, such as, but not limited to, communications systems, avionics systems, software distribution systems, network communications systems, passenger information/entertainment systems, guidance systems, radar systems, weapons systems, and the like. The aircraft 1200 may include various other structures assembled using the system 100 and/or methods 1000, 2000.

Referring to Fig. 17, during pre-production of the aircraft 1200, the manufacturing and service method 1100 includes specification and design 1102 of the aircraft 1200 and material procurement 1104. During production of the aircraft 1200, component and subassembly manufacturing 1106 and system integration 1108 of the aircraft 1200 take place. Thereafter, the aircraft 1200 goes through certification and delivery 1110 to be placed in service 1112. Routine maintenance and service 1114 includes modification, reconfiguration, refurbishment, etc. of one or more systems of the aircraft 1200.

Each of the processes of the manufacturing and service method 1100 illustrated in Fig. 17 may be performed or carried out by a system integrator, a third party, and/or an operator (e.g., a customer). For the purposes of this description, a system integrator may include, without limitation, any number of aircraft manufacturers and major-system subcontractors; a third party may include, without limitation, any number of vendors, subcontractors, and suppliers; and an operator may be an airline, leasing company, military entity, service organization, and so on.

Examples of the system 100 and the methods 1000, 2000, shown and described herein, may be employed during any one or more of the stages of the manufacturing and service method 1100 shown in the flow diagram illustrated by Fig. 17. In an example, components of the aircraft 1200 can be predictively assembled using the system 100 and/or according to the methods 1000, 2000 during a portion of component and subassembly manufacturing 1106 and/or system integration 1108. Further, components of the aircraft 1200 can be predictively assembled using the system 100 and/or according to the methods 1000, 2000 while the aircraft 1200 is in service 1112. Also, components of the aircraft 1200 can be predictively assembled using the system 100 and/or according to the methods 1000, 2000 during system integration 1108 and certification and delivery 1110. Similarly, components of the aircraft 1200 can be predictively assembled using the system 100 and/or according to the methods 1000, 2000 while the aircraft 1200 is in service 1112 and during maintenance and service 1114.

The preceding detailed description refers to the accompanying drawings, which illustrate specific examples described by the present disclosure. Other examples having different structures and operations do not depart from the scope of the present disclosure. Like reference numerals may refer to the same feature, element, or component in the different drawings. Throughout the present disclosure, any one of a plurality of items may be referred to individually as the item and a plurality of items may be referred to collectively as the items and may be referred to with like reference numerals. Moreover, as used herein, a feature, element, component, or step preceded with the word "a" or "an" should be understood as not excluding a plurality of features, elements, components, or steps, unless such exclusion is explicitly recited.

Illustrative, non-exhaustive examples, which may be, but are not necessarily, claimed, of the subject matter according to the present disclosure are provided above. Reference herein to "example" means that one or more feature, structure, element, component, characteristic, and/or operational step described in connection with the example is included in at least one aspect, embodiment, and/or implementation of the subject matter according to the present disclosure. Thus, the phrases "an example," "another example," "one or more examples," and similar language throughout the present disclosure may, but do not necessarily, refer to the same example. Further, the subject matter characterizing any one example may, but does not necessarily, include the subject matter characterizing any other example. Moreover, the subject matter characterizing any one example may be, but is not necessarily, combined with the subject matter characterizing any other example.

As used herein, a system, apparatus, device, structure, article, element, component, or hardware "configured to" perform a specified function is indeed capable of performing the specified function without any alteration, rather than merely having potential to perform the specified function after further modification. In other words, the system, apparatus, device, structure, article, element, component, or hardware "configured to" perform a specified function is specifically selected, created, implemented, utilized, programmed, and/or designed for the purpose of performing the specified function. As used herein, "configured to" denotes existing characteristics of a system, apparatus, structure, article, element, component, or hardware that enable the system, apparatus, structure, article, element, component, or hardware to perform the specified function without further modification. For purposes of this disclosure, a system, apparatus, device, structure, article, element, component, or hardware described as being "configured to" perform a particular function may additionally or alternatively be described as being "adapted to" and/or as being "operative to" perform that function.

Unless otherwise indicated, the terms "first," "second," "third," etc. are used herein merely as labels, and are not intended to impose ordinal, positional, or hierarchical requirements on the items to which these terms refer. Moreover, reference to, e.g., a "second" item does not require or preclude the existence of, e.g., a "first" or lower-numbered item, and/or, e.g., a "third" or higher-numbered item.

As used herein, the phrase "at least one of," when used with a list of items, means different combinations of one or more of the listed items may be used and only one of each item in the list may be needed. For example, "at least one of item A, item B, and item C" may include, without limitation, item A or item A and item B. This example also may include item A, item B, and item C, or item B and item C. In other examples, "at least one of' may be, for example, without limitation, two of item A, one of item B, and ten of item C; four of item B and seven of item C; and other suitable combinations. As used herein, the term "and/or" and the "/" symbol includes any and all combinations of one or more of the associated listed items.

For the purpose of this disclosure, the terms "coupled," "coupling," and similar terms refer to two or more elements that are joined, linked, fastened, attached, connected, put in communication, or otherwise associated (e.g., mechanically, electrically, fluidly, optically, electromagnetically) with one another. In various examples, the elements may be associated directly or indirectly. As an example, element A may be directly associated with element B. As another example, element A may be indirectly associated with element B, for example, via another element C. It will be understood that not all associations among the various disclosed elements are necessarily represented. Accordingly, couplings other than those depicted in the figures may also exist.

As used herein, the term "approximately" refers to or represents a condition that is close to, but not exactly, the stated condition that still performs the desired function or achieves the desired result. As an example, the term "approximately" refers to a condition that is within an acceptable predetermined tolerance or accuracy, such as to a condition that is within 10% of the stated condition. However, the term "approximately" does not exclude a condition that is exactly the stated condition. As used herein, the term "substantially" refers to a condition that is essentially the stated condition that performs the desired function or achieves the desired result.

Figs. 1-13, 16 and 18, referred to above, may represent functional elements, features, or components thereof and do not necessarily imply any particular structure. Accordingly, modifications, additions and/or omissions may be made to the illustrated structure. Additionally, those skilled in the art will appreciate that not all elements, features, and/or components described and illustrated in Figs. 1-13, 16 and 18, referred to above, need be included in every example and not all elements, features, and/or components described herein are necessarily depicted in each illustrative example. Accordingly, some of the elements, features, and/or components described and illustrated in Figs. 1-13, 16 and 18may be combined in various ways without the need to include other features described and illustrated in Figs. 1-13, 16 and 18, other drawing figures, and/or the accompanying disclosure, even though such combination or combinations are not explicitly illustrated herein. Similarly, additional features not limited to the examples presented, may be combined with some or all of the features shown and described herein. Unless otherwise explicitly stated, the schematic illustrations of the examples depicted in Figs. 1-13, 16 and 18, referred to above, are not meant to imply structural limitations with respect to the illustrative example. Rather, although one illustrative structure is indicated, it is to be understood that the structure may be modified when appropriate. Accordingly, modifications, additions and/or omissions may be made to the illustrated structure. Furthermore, elements, features, and/or components that serve a similar, or at least substantially similar, purpose are labeled with like numbers in each of Figs. 1-13, 16 and 18, and such elements, features, and/or components may not be discussed in detail herein with reference to each of Figs. 1-13, 16 and 18. Similarly, all elements, features, and/or components may not be labeled in each of Figs. 1-13, 16 and 18, but reference numerals associated therewith may be utilized herein for consistency.

In Figs. 14, 15 and 17, referred to above, the blocks may represent operations, steps, and/or portions thereof and lines connecting the various blocks do not imply any particular order or dependency of the operations or portions thereof. It will be understood that not all dependencies among the various disclosed operations are necessarily represented. Figs. 14, 15 and 17 and the accompanying disclosure describing the operations of the disclosed methods set forth herein should not be interpreted as necessarily determining a sequence in which the operations are to be performed. Rather, although one illustrative order is indicated, it is to be understood that the sequence of the operations may be modified when appropriate. Accordingly, modifications, additions and/or omissions may be made to the operations illustrated and certain operations may be performed in a different order or simultaneously. Additionally, those skilled in the art will appreciate that not all operations described need be performed.

Further, references throughout the present specification to features, advantages, or similar language used herein do not imply that all of the features and advantages that may be realized with the examples disclosed herein should be, or are in, any single example. Rather, language referring to the features and advantages is understood to mean that a specific feature, advantage, or characteristic described in connection with an example is included in at least one example. Thus, discussion of features, advantages, and similar language used throughout the present disclosure may, but does not necessarily, refer to the same example.

The described features, advantages, and characteristics of one example may be combined in any suitable manner in one or more other examples. One skilled in the relevant art will recognize that the examples described herein may be practiced without one or more of the specific features or advantages of a particular example. In other instances, additional features and advantages may be recognized in certain examples that may not be present in all examples. Furthermore, although various examples of the system 100, the method 1000, the method 2000, and the computer program product 922 have been shown and described, modifications may occur to those skilled in the art upon reading the specification. The present application includes such modifications and is limited only by the scope of the claims.

## Claims

1. A system (100) comprises:
a model generator (102) that generates a first model (104) of a first component (106) and a second model (108) of a second component (110) before the first component (106) and the second component (110) are coupled together; and
a model analyzer (112) that analyzes the first model (104) and the second model (108) to determine a dimension (114) of a gap (116) between a first mating surface (118) of the first component (106) and a second mating surface (120) of the second component (110) after the first component (106) and the second component (110) are coupled together; and
an assembly planner (210) that recommends an action (212) based on a comparison of the gap (116) to a gap threshold (214).

2. The system (100) of Claim 1, wherein the action (212) recommended by the assembly planner (210) comprises coupling the first component (106) and the second component (110) together when the dimension (114) of the gap (116) is less than or equal to the gap threshold (214); or
wherein the action (212) recommended by the assembly planner (210) comprises reprocessing at least one of the first component (106) and the second component (110) when the dimension (114) of the gap (116) is greater than the gap threshold (214) ; or
wherein the action (212) recommended by the assembly planner (210) comprises redesigning at least one of the first component (106) and the second component (110) when the dimension (114) of the gap (116) is greater than the gap threshold (214); or
wherein the action (212) recommended by the assembly planner (210) comprises repairing at least one of the first component (106) and the second component (110) when the dimension (114) of the gap (116) is greater than the gap threshold (214).

3. The system (100) of Claim 1 or 2, wherein:
the model analyzer (112):
modifies a first nominal model (124) of the first component (106) by a first waviness deviation (134); and
modifies a second nominal model (224) of the second component (110) by a second waviness deviation (234);
a first modified nominal model (190) represents the first mating surface (118) of the first component (106) after the first component (106) and the second component (110) are coupled together; and
a second modified nominal model (290) represents the second mating surface (120) of the second component (110) after the first component (106) and the second component (110) are coupled together; and
the dimension (114) of the gap (116) is determined using the first modified nominal model (190) and the second modified nominal model (290).

4. The system (100) of Claim 3, wherein:
the model analyzer (112):
determines a first overall deviation (122) in a normal direction between the first model (104) and the first nominal model (124) of the first component (106); and
determines a second overall deviation (222) in the normal direction between the second model (108) and the second nominal model (224) of the second component (110);
the first waviness deviation (134) is derived from the first overall deviation (122); and
the second waviness deviation (234) is derived from the second overall deviation (222).

5. The system (100) of Claim 4, wherein the model analyzer (112):
performs a best fit alignment between the first model (104) and a first nominal model (124) of the first component (106) to determine a first overall deviation (122); and
performs the best fit alignment between the second model (108) and a second nominal model (224) of the second component (110) to determine a second overall deviation (222).

6. The system (100) of Claim 5, wherein the model analyzer (112):
determines a first overall dimension (164) of the first overall deviation (122) in the normal direction;
determines a second overall dimension (264) of the second overall deviation (222) in the normal direction;
maps the first overall deviation (122) from an XYZ-coordinate system (126) to a UVW-coordinate system (128) such that the first overall dimensions (164) of the first overall deviation (122) are represented along a W-axis (152);
maps the second overall deviation (222) from the XYZ-coordinate system (126) to the UVW-coordinate system (128) such that the second overall dimensions (264) of the second overall deviation (222) are represented along the W-axis (152);
filters the first overall dimensions (164) of the first overall deviation (122) into a first form deviation (132) and a first waviness deviation (134); and
filters the second overall dimensions (264) of the second overall deviation (222) into a second form deviation (232) and a second waviness deviation (234).

7. The system (100) of Claim 6, wherein the model analyzer (112):
maps the first waviness deviation (134) from the UVW-coordinate system (128) to the XYZ-coordinate system (126) such that first waviness dimensions (168) of the first waviness deviation (134) are represented as first distances (160) relative to the first nominal model (124); and
maps the second waviness deviation (234) from the UVW-coordinate system (128) to the XYZ-coordinate system (126) such that second waviness dimensions (268) of the second waviness deviation (234) are represented as second distances (260) relative to the second nominal model (224).

8. The system (100) of any preceding Claim, further comprising a measurement system (136) to generate first data (138) representing at least a portion of the first mating surface (118) of the first component (106) and second data (140) representing at least a portion of the second mating surface (120) of the second component (110) before the first mating surface (118) and the second mating surface (120) are mated.

9. The system (100) of any preceding Claim, wherein the model generator (102), the model analyzer (112), and the assembly planner (210) take the form of program code (918) that is executed by a data processing system (900).

10. A method (1000) for predictive assembly, the method (1000) comprising:
generating a first model (104) of a first component (106) and a second model (108) of a second component (110) before the first component (106) and the second component (110) are coupled together;
analyzing the first model (104) and the second model (108) to determine a dimension (114) of a gap (116) between a first mating surface (118) of the first component (106) and a second mating surface (120) of the second component (110) after the first component (106) and the second component (110) are coupled together; and
recommending an action (212) based on a comparison of the gap (116) to a gap threshold (214).

11. The method (1000) of Claim 10, wherein the action (212) comprises coupling the first component (106) and the second component (110) together when the dimension (114) of the gap (116) is less than or equal to the gap threshold (214); or
wherein the action (212) comprises reprocessing at least one of the first component (106) and the second component (110) when the dimension (114) of the gap (116) is greater than the gap threshold (214); or
wherein the action (212) comprises redesigning at least one of the first component (106) and the second component (110) when the dimension (114) of the gap (116) is greater than the gap threshold (214).

12. The method (1000) of Claim 10, wherein the action (212) comprises repairing at least one of the first component (106) and the second component (110) when the dimension (114) of the gap (116) is greater than the gap threshold (214).

13. The method (1000) of any of Claims 10 to 12, further comprising
modifying a first nominal model (124) of the first component (106) by a first waviness deviation (134); and
modifying a second nominal model (224) of the second component (110) by a second waviness deviation (234),
wherein:
a first modified nominal model (190) represents the first mating surface (118) of the first component (106) after the first component (106) and the second component (110) are coupled together; and
a second modified nominal model (290) represents the second mating surface (120) of the second component (110) after the first component (106) and the second component (110) are coupled together; and
the dimension (114) of the gap (116) is determined using the first modified nominal model (190) and the second modified nominal model (290).

14. The method (1000) of Claim 13, further comprising:
determining a first overall deviation (122) in a normal direction between the first model (104) and the first nominal model (124) of the first component (106);
determining a second overall deviation (222) in the normal direction between the second model (108) and the second nominal model (224) of the second component (110);
performing a best fit alignment between the first model (104) and the first nominal model (124) of the first component (106) to determine the first overall deviation (122);
performing the best fit alignment between the second model (108) and the second nominal model (224) of the second component (110) to determine the second overall deviation (222);
determining a first overall dimension (164) of the first overall deviation (122) in the normal direction;
determining a second overall dimension (264) of the second overall deviation (222) in the normal direction;
mapping the first overall deviation (122) from an XYZ-coordinate system (126) to a UVW-coordinate system (128) such that the first overall dimensions (164) of the first overall deviation (122) are represented along a W-axis (152);
mapping the second overall deviation (222) from the XYZ-coordinate system (126) to the UVW-coordinate system (128) such that the second overall dimensions (264) of the second overall deviation (222) are represented along the W-axis (152);
filtering the first overall dimensions (164) of the first overall deviation (122) into a first form deviation (132) and the first waviness deviation (134);
filtering the second overall dimensions (264) of the second overall deviation (222) into a second form deviation (232) and the second waviness deviation (234);
mapping the first waviness deviation (134) from the UVW-coordinate system (128) to the XYZ-coordinate system (126) such that first waviness dimensions (168) of the first waviness deviation (134) are represented as first distances (160) relative to the first nominal model (124); and
mapping the second waviness deviation (234) from the UVW-coordinate system (128) to the XYZ-coordinate system (126) such that second waviness dimensions (268) of the second waviness deviation (234) are represented as second distances (260) relative to the second nominal model (224).

15. A computer-readable medium (920) comprising program code (918) that, when executed by one or more processors (904), causes the one or more processors (904) to perform operations comprising the method of any of claims 10 to 14.
